# EUROPEAN PATENT APPLICATION

(11) **EP 4 770 362 A1**
(43) Date of publication of application: **01.07.2026**
(21) Application number: 25226437.9
(22) Date of filing: 22.12.2025
(51) Int. Cl.: H10K 50/11, H10K 59/12, H10K 59/122, H10K 59/80, H10K 59/38

(54) **DISPLAY APPARATUS, METHOD OF MANUFACTURING THE DISPLAY APPARATUS, AND ELECTRONIC APPARATUS**

(30) Priority: 26.12.2024 KR 20240197378
(71) Applicant: Samsung Display Co., Ltd., Yongin-si, Gyeonggi-do 17113 (KR)
(72) Inventor: Sakamoto, Yoshiaki, 17113 Yongin-si, Gyeonggi-do (KR)
(74) Representative: Gulde & Partner

(57) **Abstract**

Provided is a display apparatus including a substrate, a planarization layer above the substrate, a first pixel electrode above the planarization layer, an emission layer above the first pixel electrode, an opposite electrode above the emission layer, and a pixel-defining layer between the emission layer and the opposite electrode, and defining a first pixel opening overlapping the first pixel electrode.

## Description

### BACKGROUND

### 1. Field

One or more embodiments relate to a display apparatus including an emission layer with substantially uniform thickness so that the emission efficiency is improved, a method of manufacturing the display apparatus, and an electronic apparatus.

### 2. Description of the Related Art

To support various functions, electronic apparatuses include display apparatuses capable of providing users with visual information, such as an image or video. Such display apparatuses have display elements, such as an organic light-emitting diode, and thin-film transistors formed on a substrate, and operate by allowing the display elements to emit light. For example, a display element may include an emission layer between a pixel electrode and an opposite electrode. When a thickness of the emission layer of the display element is not uniform, the electrical field applied to the emission layer is not uniform, and thus, an emission area decreases, and accordingly, the emission efficiency is reduced.

### SUMMARY

In display apparatuses according to the related art, because the emission layer is formed in an opening defined in a pixel-defining layer, a thickness of an emission layer is not uniform, which could reduce the emission efficiency.

One or more embodiments include a display apparatus including an emission layer with substantially uniform thickness so that the emission efficiency is improved, a method of manufacturing the display apparatus, and an electronic apparatus. However, this is merely an example, and the scope of the disclosure is not limited thereby.

Additional aspects will be set forth in part in the description which follows and, in part, will be apparent from the description, or may be learned by practice of the presented embodiments of the disclosure.

According to one or more embodiments, a display apparatus includes a substrate, a planarization layer above the substrate, a first pixel electrode above the planarization layer, an emission layer above the first pixel electrode, an opposite electrode above the emission layer, and a pixel-defining layer between the emission layer and the opposite electrode, and defining a first pixel opening overlapping the first pixel electrode.

A portion of the emission layer may be between a portion of the pixel-defining layer defining the first pixel opening and a portion of the first pixel electrode, wherein another portion of the emission layer is between a portion of the opposite electrode overlapping the first pixel opening and another portion of the first pixel electrode.

The display apparatus may further include a second pixel electrode above the planarization layer, and spaced apart from the first pixel electrode, and a third pixel electrode above the planarization layer opposite the second pixel electrode with the first pixel electrode therebetween, wherein the emission layer overlaps the first pixel electrode, the second pixel electrode, and the third pixel electrode, and wherein the pixel-defining layer defines a second pixel opening overlapping the second pixel electrode, and a third pixel opening overlapping the third pixel electrode.

Portions of the emission layer may be respectively between the first pixel electrode and the second pixel electrode and between the first pixel electrode and the third pixel electrode.

The display apparatus may further include an encapsulation layer above the opposite electrode, and including at least one inorganic layer and at least one organic layer, a light-shielding wall portion above the encapsulation layer, and defining a first color conversion opening overlapping the first pixel opening, a second color conversion opening overlapping the second pixel opening, and a light-transmissive opening overlapping the third pixel opening.

The display apparatus may further include a first color conversion layer in the first color conversion opening, a second color conversion layer in the second color conversion opening, and a light-transmissive layer in the light-transmissive opening.

The display apparatus may further include an encapsulation layer above the opposite electrode, and including at least one inorganic layer and at least one organic layer, a light-shielding wall portion above the encapsulation layer, and defining a first color conversion opening overlapping the first pixel opening, a second color conversion opening overlapping the second pixel opening, and a third color conversion opening overlapping the third pixel opening.

The display apparatus may further include a first color filter layer in the first color conversion opening, a second color filter layer in the second color conversion opening, and a third color filter layer in the third color conversion opening.

The display apparatus may further include a planarization auxiliary layer above the planarization layer between the first pixel electrode and the second pixel electrode and between the first pixel electrode and the third pixel electrode, directly contacting the planarization layer, and directly contacting portions of the emission layer respectively between the first pixel electrode and the second pixel electrode and between the first pixel electrode and the third pixel electrode.

An upper surface of the planarization auxiliary layer, an upper surface of the first pixel electrode, an upper surface of the second pixel electrode, and an upper surface of the third pixel electrode may be substantially coplanar.

The planarization auxiliary layer may include a same material as the planarization layer.

The display apparatus may further include a second pixel electrode above the planarization layer, and spaced apart from the first pixel electrode, and a third pixel electrode above the planarization layer, and opposite to the second pixel electrode with the first pixel electrode therebetween.

The emission layer may include a first emission layer between the first pixel electrode and the opposite electrode, a second emission layer between the second pixel electrode and the opposite electrode, and a third emission layer between the third pixel electrode and the opposite electrode, the first, second, and third emission layers being spaced apart from each other.

The pixel-defining layer may define a second pixel opening overlapping the second pixel electrode, and a third pixel opening overlapping the third pixel electrode.

Portions of the pixel-defining layer respectively between the first emission layer and the second emission layer and between the first emission layer and the third emission layer may directly contact the planarization layer.

The display apparatus may further include a planarization auxiliary layer above the planarization layer between the first pixel electrode and the second pixel electrode and between the first pixel electrode and the third pixel electrode, directly contacting the planarization layer, and directly contacting portions of the pixel-defining layer respectively between the first pixel electrode and the second pixel electrode and between the first pixel electrode and the third pixel electrode.

An upper surface of the planarization auxiliary layer, an upper surface of the first pixel electrode, an upper surface of the second pixel electrode, and an upper surface of the third pixel electrode may be substantially coplanar.

The planarization auxiliary layer may include a same material as the planarization layer.

According to one or more embodiments, a method of manufacturing a display apparatus includes placing a first pixel electrode above a planarization layer that is above a substrate, placing an emission layer above the first pixel electrode, placing a pixel-defining layer above the emission layer and defining a first pixel opening overlapping the first pixel electrode, and placing an opposite electrode above the pixel-defining layer.

A portion of the emission layer may be between a portion of the pixel-defining layer defining the first pixel opening and a portion of the first pixel electrode, wherein another portion of the emission layer is between a portion of the opposite electrode overlapping the first pixel opening and another portion of the first pixel electrode.

The method may further include placing a second pixel electrode spaced apart from the first pixel electrode, and a third pixel electrode opposite the second pixel electrode with the first pixel electrode therebetween, above the planarization layer, covering the first pixel electrode, the second pixel electrode, and the third pixel electrode with a preliminary planarization auxiliary layer, removing a portion of the preliminary planarization auxiliary layer, and forming a planarization auxiliary layer having an upper surface that is substantially coplanar with an upper surface of the first pixel electrode, an upper surface of the second pixel electrode, and an upper surface of the third pixel electrode. The emission layer may be integral across the first pixel electrode, the second pixel electrode, and the third pixel electrode. The placing of the pixel-defining layer may include applying a pixel-defining-layer-forming material between a central portion of the first pixel electrode and a central portion of the second pixel electrode, and between a central portion of the first pixel electrode and a central portion of the third pixel electrode, and performing heat treatment on the pixel-defining-layer-forming material. The placing of the planarization auxiliary layer may be performed between the placing of the first pixel electrode and the placing of the emission layer.

The method may further include placing a second pixel electrode apart from the first pixel electrode, and a third pixel electrode opposite the second pixel electrode with the first pixel electrode positioned therebetween, above the planarization layer. The placing of the emission layer may include integrally placing a preliminary emission layer across the first pixel electrode, the second pixel electrode, and the third pixel electrode, and removing a portion of the preliminary emission layer above the planarization layer between the first pixel electrode and the second pixel electrode and between the first pixel electrode and the third pixel electrode. The placing of the pixel-defining layer may include applying a pixel-defining-layer-forming material between a central portion of the first pixel electrode and a central portion of the second pixel electrode and between a central portion of the first pixel electrode and a central portion of the third pixel electrode, and performing heat treatment on the pixel-defining-layer-forming material.

The method may further include, between the placing of the first pixel electrode and the placing of the emission layer, placing a planarization auxiliary layer having an upper surface that is substantially coplanar with an upper surface of the first pixel electrode, an upper surface of the second pixel electrode, and an upper surface of the third pixel electrode by covering the first pixel electrode, the second pixel electrode, and the third pixel electrode with a preliminary planarization auxiliary layer and removing a portion of the preliminary planarization auxiliary layer.

According to one or more embodiments, an electronic apparatus includes a display apparatus, and a housing accommodating the display apparatus and forming an exterior of the electronic apparatus, wherein the display apparatus includes a substrate, a planarization layer above the substrate, a first pixel electrode above the planarization layer, an emission layer above the first pixel electrode, an opposite electrode above the emission layer, and a pixel-defining layer between the emission layer and the opposite electrode and defining a first pixel opening overlapping the first pixel electrode.

Aspects other than those described above will become apparent from the following detailed description, claims, and drawings for working the disclosure.

### BRIEF DESCRIPTION OF THE DRAWINGS

The above and other aspects of certain embodiments of the disclosure will be more apparent from the following description taken in conjunction with the accompanying drawings, in which:
FIG. 1 is a perspective view schematically illustrating an electronic apparatus according to one or more embodiments;
FIG. 2 is a plan view schematically illustrating a display apparatus according to one or more embodiments;
FIG. 3 is an equivalent circuit diagram of a pixel circuit included in the display apparatus of FIG. 2;
FIG. 4 is an enlarged plan view schematically illustrating region A of the display apparatus of FIG. 2;
FIG. 5 is a cross-sectional view schematically illustrating a cross-section of the display apparatus of FIG. 4, taken along the line I-I';
FIG. 6 is an enlarged cross-sectional view schematically illustrating region B of the display apparatus of FIG. 5;
FIG. 7 is a diagram for describing a first color conversion layer, a second color conversion layer, and a light-transmitting layer included in a display apparatus according to one or more embodiments;
FIG. 8 is a cross-sectional view schematically illustrating a display apparatus according to one or more embodiments;
FIG. 9 is a cross-sectional view schematically illustrating a display apparatus according to one or more embodiments;
FIG. 10 is a cross-sectional view schematically illustrating a display apparatus according to one or more embodiments;
FIGS. 11 to 15 are cross-sectional views schematically illustrating a portion of a process of manufacturing the display apparatus of FIG. 5;
FIGS. 16 to 18 are schematic cross-sectional views for describing a method of manufacturing a display apparatus, according to one or more embodiments;
FIGS. 19 to 21 are schematic cross-sectional views for describing a method of manufacturing a display apparatus, according to one or more embodiments;
FIGS. 22 to 24 are schematic cross-sectional views for describing a method of manufacturing a display apparatus, according to one or more embodiments; and
FIG. 25 is a cross-sectional view schematically illustrating the display apparatus according to one or more embodiments.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above. In other words, the expression "in a plan view" as used herein may mean "when viewed from a direction perpendicular to a substrate 100." The phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same". In other words, the expression "being the same" may include a range that can be tolerated by those of ordinary skill in the art. The other expressions may also be expressions from which "substantially" has been omitted.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

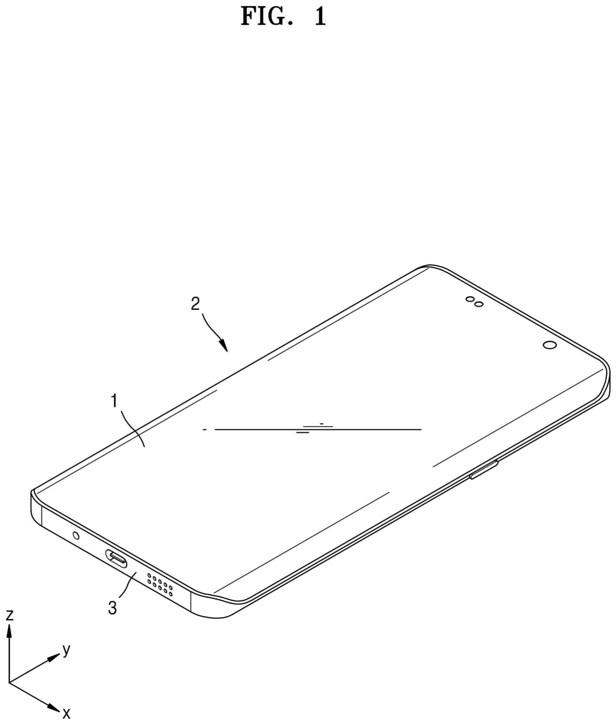

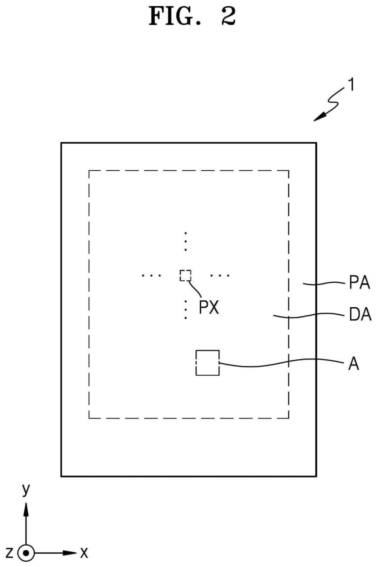

FIG. 1 is a perspective view schematically illustrating an electronic apparatus 2 according to one or more embodiments. FIG. 2 is a plan view schematically illustrating a display apparatus 1 according to one or more embodiments.

As shown in FIGS. 1 and 2, the display apparatus 1 displays moving images or still images, and may display a screen on the electronic apparatus 2 or perform input or output of data.

In FIG. 1, the display apparatus 1 is used for a mobile phone, according to one or more embodiments. However, other embodiments are not limited thereto. For example, the display apparatus 1 may be used not only for a portable electronic apparatus, such as a mobile phone, a smartphone, a tablet personal computer (PC), a mobile communication terminal, an electronic notebook, an electronic book, a portable multimedia player (PMP), a navigation, or an ultra-mobile PC (UMPC), but also as a display screen of various electronic apparatuses, such as a television, a laptop PC, a monitor, a billboard, or an Internet of things (loT) device.

In addition, in one or more embodiments, the display apparatus 1 may be used for electronic apparatuses such as wearable devices, such as a smart watch, a watch phone, an eyeglasses-type display, or a head-mounted display (HMD). In one or more embodiments, the display apparatus 1 may be used as a display of various electronic apparatuses, such as an instrument panel of a vehicle, a center information display (CID) arranged on a center fascia or dashboard of a vehicle, a room mirror display replacing a side-view mirror of a vehicle, or a display arranged on the rear surface of a front seat for an entertainment for the backseat of a vehicle.

In one or more embodiments, the display apparatus 1 may be accommodated in a housing 3 of the electronic apparatus 2. The housing 3 may protect internal elements, such as the display apparatus 1, and may be a cover forming the exterior of the electronic apparatus 2. In addition, the display apparatus 1 may be connected to an electronic module of the electronic apparatus 2 and may operate based on the electronic apparatus 2. The display apparatus 1 is mainly described below.

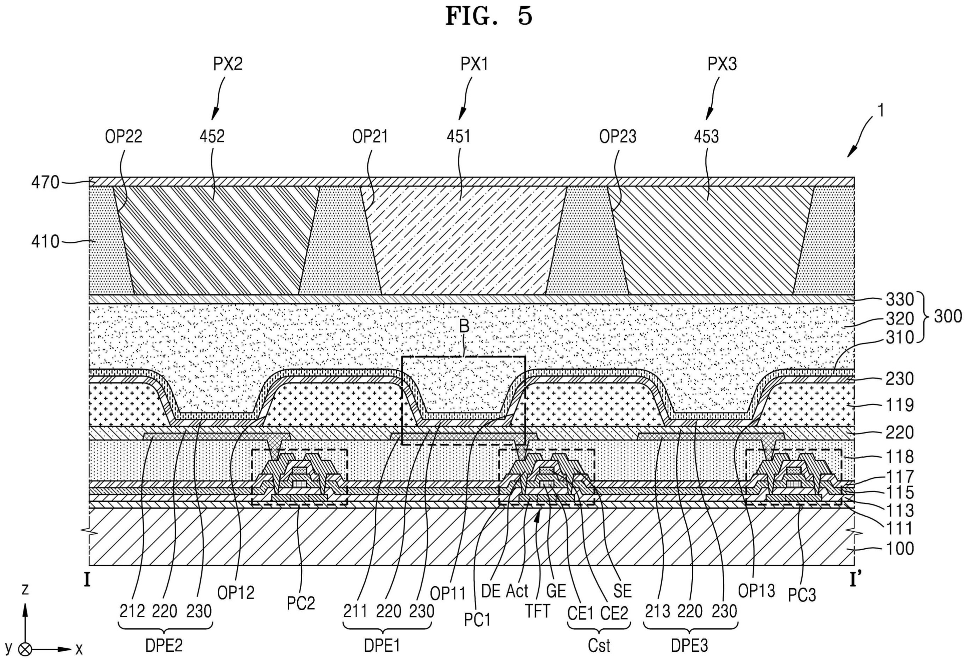

As shown in FIG. 2, the display apparatus 1 may include a display area DA in which a plurality of pixels PX are arranged, and a peripheral area PA positioned outside the display area DA. For example, the peripheral area PA may surround the display area DA entirely (e.g., in plan view). This may be understood that the substrate 100 (see FIG. 5) included in the display apparatus has the display area DA and the peripheral area PA.

Each of the pixels PX of the display apparatus 1 is an area in which light of a certain color may be emitted, and the display apparatus 1 may provide an image by using light emitted from the pixels PX. For example, each of the pixels PX may emit red light, green light, or blue light.

The display area DA may have a polygonal shape, such as a quadrilateral, as shown in FIG. 2. For example, the display area DA may have a rectangular shape of which the horizontal length is greater than the vertical length, a rectangular shape of which the horizontal length is less than the vertical length, or a square shape. In some embodiments, the display area DA may have various shapes, such as an elliptical shape or circular shape.

The peripheral area PA may be a non-display area in which no pixels PX are arranged. A driver or the like for providing electrical signals or power to the pixels PX may be arranged in the peripheral area PA. In one or more embodiments, there may be arranged in the peripheral area PA one or more pads, to which various electronic elements, a printed circuit board, or the like may be electrically connected. The pads may be spaced apart from each other in the peripheral area PA, and may be electrically connected to a printed circuit board or integrated circuit element.

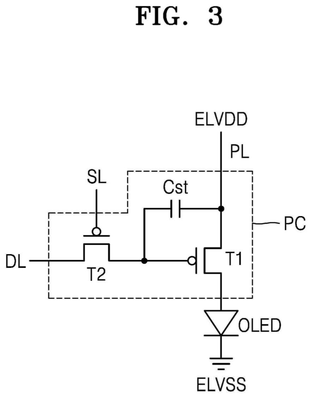

FIG. 3 is an equivalent circuit diagram of a pixel circuit PC included in the display apparatus 1 according to one or more embodiments. The pixel circuit PC may be electrically connected to the display element, and one display element may correspond to one pixel PX. In FIG. 3, an organic light-emitting diode OLED is shown as a display element.

The pixel circuit PC may include a first transistor T1, a second transistor T2, and a storage capacitor Cst. The second transistor T2, which is a switching transistor, may be connected to a scan line SL and a data line DL. The second transistor T2 may be turned on according to a switching signal received from the scan line SL to transfer a data signal received from the data line DL to the first transistor T1. The storage capacitor Cst may have one end electrically connected to the second transistor T2 and the other end electrically connected to a driving voltage line PL, and may store a voltage corresponding to a difference between a voltage received from the second transistor T2 and a driving power voltage ELVDD supplied to the driving voltage line PL.

The first transistor T1, which is a driving transistor, may be connected to the driving voltage line PL and the storage capacitor Cst. The first transistor T1 may control a magnitude of a driving current flowing from the driving voltage line PL to the organic light-emitting diode OLED in response to a voltage value stored in the storage capacitor Cst. The organic light-emitting diode OLED may emit light having a certain luminance according to the driving current. An opposite electrode of the organic light-emitting diode OLED may receive an electrode power voltage ELVSS.

In FIG. 3, the pixel circuit PC includes two transistor and one storage capacitor. However, other embodiments are not limited thereto. For example, the number of transistors and the number of storage capacitors may be variously modified according to the design of the pixel circuit PC.

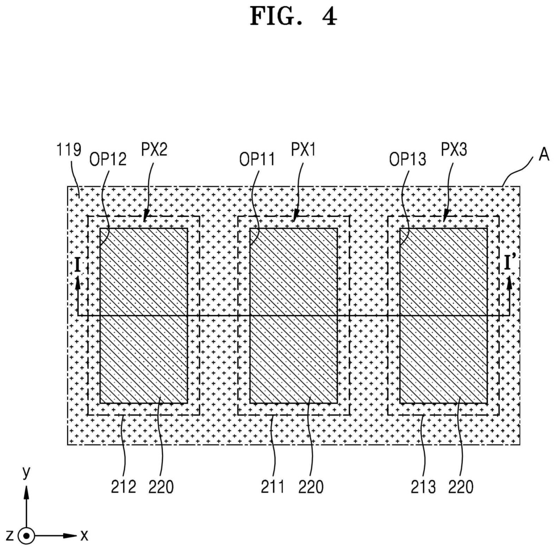

FIG. 4 is an enlarged plan view schematically illustrating region A of the display apparatus 1 of FIG. 2. For convenience, FIG. 4 shows a plan view on a pixel-defining layer 119. However, for convenience of description, pixel electrodes arranged under the pixel-defining layer 119 are also shown.

As described above, a plurality of pixels PX may be arranged in the display area DA. Each of the pixels PX may emit red light, green light, or blue light. A display element, such as an organic light-emitting diode, may correspond to each of the pixels PX. For example, a plurality of display elements included in the display apparatus 1 may correspond to the respective pixels PX of the display apparatus 1, and each of the plurality of display elements may emit light. Herein, when one display element corresponds to one pixel or one pixel corresponds to one display element, it means that one pixel refers to an emission area of one display element.

As shown in FIG. 4, the pixel PX may be a first pixel PX1 which emits green light, a second pixel PX2 which emits red light, or a third pixel PX3 which emits blue light. In other words, the plurality of pixels PX may include the first pixel PX1, the second pixel PX2, and the third pixel PX3. Green light is light which belongs to a wavelength band of about 495 nm to about 580 nm, red light is light which belongs to a wavelength and of about 580 nm to about 780nm, and blue light is light which belongs to a wavelength band of about 400 nm to about 495 nm.

A stack structure of a pixel electrode, an emission layer, and an opposite electrode may constitute one display element (e.g., an organic light-emitting diode). For example, a plurality of pixel electrodes may be arranged on the display area DA of the substrate 100. In a plan view, the plurality of pixel electrodes may be spaced apart from each other. For example, a first pixel electrode 211 and a second pixel electrode 212 may be spaced apart from each other in a first direction (e.g., an x-axis direction), and a third pixel electrode 213 may be positioned in the opposite direction of the second pixel electrode 212 with the first pixel electrode 211 between the third pixel electrode 213 and the second pixel electrode 212. An emission layer 220 may be arranged on the first pixel electrode 211, the second pixel electrode 212, and the third pixel electrode 213 (as used herein, "arranged on" may mean "above").

The pixel-defining layer 119 may be arranged over the first pixel electrode 211, the second pixel electrode 212, and the third pixel electrode 213. For example, the pixel-defining layer 119 may be arranged on an emission layer 220. The pixel-defining layer 119 may define a first pixel opening OP11, a second pixel opening OP12, and a third pixel opening OP13. In a plan view, the first pixel opening OP11 may overlap the first pixel electrode 211. In a plan view, the second pixel opening OP12 may overlap the second pixel electrode 212, and the third pixel opening OP13 may overlap the third pixel electrode 213. Accordingly, the first pixel opening OP11 may expose the emission layer 220 arranged on a central portion of the first pixel electrode 211. Similarly, the second pixel opening OP12 may expose the emission layer 220 arranged on a central portion of the second pixel electrode 212. Also, the third pixel opening OP13 may expose the emission layer 220 arranged on a central portion of the third pixel electrode 213. In one or more embodiments, the opposite electrode may be arranged on the emission layer 220.

Accordingly, one pixel opening of the pixel-defining layer 119 may define an emission area of one display element. An emission area defined by a pixel opening may be defined as the pixel PX. For example, an emission area defined by the first pixel opening OP11 may be defined as the first pixel PX1. Similarly, an emission area defined by the second pixel opening OP12 may be defined as the second pixel PX2. Also, an emission area defined by the third pixel opening OP13 may be defined as the third pixel PX3. In FIG. 4, the first pixel opening OP11, the second pixel opening OP12, and the third pixel opening OP13 are substantially the same in size. However, other embodiments are not limited thereto. The first pixel opening OP11, the second pixel opening OP12, and the third pixel opening OP13 may have different sizes.

In FIG. 4, one first pixel PX1, one second pixel PX2, and one third pixel PX3 are shown. However, other embodiments are not limited thereto. The first pixel PX1, the second pixel PX2, and the third pixel PX3 may be repeatedly arranged in the first direction (e.g., the x-axis direction) and/or a second direction (e.g., a y-axis direction). For example, based on FIG. 4, the second pixel PX2 may be arranged in a +x direction of the third pixel PX3, and the third pixel PX3 may be arranged in a -x direction of the second pixel PX2. Accordingly, display elements respectively corresponding to the first pixel PX1, the second pixel PX2, and the third pixel PX3 and pixel circuits electrically connected to the respective display elements may also be repeatedly arranged in the first direction (e.g., the x-axis direction) or the second direction (e.g., the y-axis direction).

FIG. 5 is a cross-sectional view schematically illustrating a cross-section of the display apparatus 1 of FIG. 4, taken along the line I-I'. As shown in FIG. 5, the display apparatus 1 may include the substrate 100.

The substrate 100 may include various materials having flexible or bendable properties. For example, the substrate 100 may include glass, metal, or polymer resin. In addition, the substrate 100 may include polymer resin, such as polyethersulfone, polyacrylate, polyetherimide, polyethylene naphthalate, polyethylene terephthalate, polyphenylene sulfide, polyarylate, polyimide, polycarbonate, or cellulose acetate propionate. The substrate 100 may be variously modified, such as a multi-layer structure, which includes two layers each including the polymer resin described above and a barrier layer positioned between the two layers and including an inorganic material, such as silicon oxide (SiOx), silicon nitride (SiNx), and/or silicon oxynitride (SiOxNy).

A plurality of display elements and a plurality of pixel circuits electrically connected to those display elements may be arranged on the substrate 100. For example, a first pixel circuit PC1, a second pixel circuit PC2, and a third pixel circuit PC3 may be arranged on the substrate 100. Each of the first pixel circuit PC1, the second pixel circuit PC2, and the third pixel circuit PC3 may be electrically connected to a corresponding one of a first display element DPE1, a second display element DPE2, or a third display element DPE3.

Because the first pixel circuit PC1, the second pixel circuit PC2, and the third pixel circuit PC3 are same in structure, the description is mainly focused on the first pixel circuit PC1. The first pixel circuit PC1 may include a plurality of transistors TFT and the storage capacitor Cst. For convenience of description, FIG. 5 shows one transistor TFT, which may correspond to the first transistor T1 (see FIG. 3).

A buffer layer 111, which may include an inorganic material, such as SiOₓ, SiNₓ, and/or SiOₓN_{y}, may be positioned between the transistor TFT and the substrate 100. The buffer layer 111 may increase flatness of an upper surface of the substrate 100 or may prevent, reduce, or minimize permeation of impurities from the substrate 100 or the like into a semiconductor layer Act of the transistor TFT.

As shown in FIG. 5, the transistor TFT may include the semiconductor layer Act, which may include amorphous silicon, polycrystalline silicon, an organic semiconductor material, or an oxide semiconductor material. Further, the transistor TFT may include a gate electrode GE, a source electrode SE, and/or a drain electrode DE. The gate electrode GE may include various conductive materials and may have various layered structures (e.g., a molybdenum (Mo) layer and an aluminum (Al) layer). In some embodiments, the gate electrode GE may include a titanium nitride (TiNx) layer, an Al layer, and/or a titanium (Ti) layer. The source electrode SE and the drain electrode DE may include various conductive materials and may have various layered structures (e.g., a Ti layer, an Al layer, and/or a copper (Cu) layer).

To ensure insulation with the semiconductor layer Act and the gate electrode GE, a gate-insulating layer 113, which may include an inorganic material, such as SiOₓ, SiNₓ, and/or SiOₓN_{y}, may be positioned between the semiconductor layer Act and the gate electrode GE. In FIG. 5, the gate-insulating layer 113 has a shape corresponding to the entire surface of the substrate 100 and a structure in which contact holes are defined in a preset portions. However, other embodiments are not limited thereto. For example, the gate-insulating layer 113 may be patterned into the same shape as the gate electrode GE.

In addition, a first interlayer insulating layer 115, which may include SiOₓ, SiNₓ, and/or SiOₓN_{y}, may be arranged on the gate electrode GE. The first interlayer insulating layer 115 may have a layer or layers including the above-described materials. Such an insulating layer including an inorganic insulating material may be formed through chemical vapor deposition (CVD) or atomic layer deposition (ALD). This also applies to embodiments described below and modifications thereof.

The storage capacitor Cst may include a first capacitor electrode CE1 and a second capacitor electrode CE2, which overlap each other with the first interlayer insulating layer 115 between the first capacitor electrode CE1 and the second capacitor electrode CE2. The storage capacitor Cst may overlap the transistor TFT. Regarding the above, FIG. 5 shows that the gate electrode GE of the transistor TFT is the first capacitor electrode CE1 of the storage capacitor Cst. However, other embodiments are not limited thereto. For example, the storage capacitor Cst may not overlap the transistor TFT. The second capacitor electrode CE2 of the storage capacitor Cst may include a conductive material, such as Mo, Al, Cu, or Ti, and may have a layer or layers including those materials.

A second interlayer insulating layer 117, which may include an inorganic material, such as SiOₓ, SiNₓ, and/or SiOₓN_{y}, may be arranged on the second capacitor electrode CE2 of the storage capacitor Cst. The second interlayer insulating layer 117 may have a layer or layers including the above-described materials.

The source electrode SE and the drain electrode DE may be arranged on this second interlayer insulating layer 117. The source electrode SE and the drain electrode DE may include a material having excellent conductivity. The source electrode SE and the drain electrode DE may include a conductive material, such as Mo, Al, Cu, or Ti, and may have a layer or layers including those materials. For example, the source electrode SE and the drain electrode DE may have a multi-layer structure of Ti/Al/Ti.

However, other embodiments are not limited thereto. For example, the transistor TFT may include only one of the source electrode SE or the drain electrode DE, or neither of them. For example, one transistor TFT may not have the drain electrode DE, the other transistor TFT connected to that one transistor TFT may not have the source electrode SE, and the semiconductor layers Act of the respective transistors may be connected to each other. Such a connection structure may bring about the same effect as when the one transistor TFT even has the source electrode SE, the other transistor TFT even has the drain electrode DE, and the source electrode SE of the one transistor TFT is connected to the drain electrode DE of the other transistor TFT.

As shown in FIG. 5, a planarization layer 118 may cover the transistor TFT and the storage capacitor Cst. In other words, the planarization layer 118 may be arranged on the substrate 100. The planarization layer 118 may include an organic insulating material. For example, the planarization layer 118 may include a photoresist, benzocyclobutene (BCB), polyimide, hexamethyldisiloxane (HMDSO), polymethylmethacrylate (PMMA), polystyrene, a polymer derivative having a phenol-based group, an acryl-based polymer, an imide-based polymer, aryl ether-based polymer, an amide-based polymer, a fluorine-based polymer, a p-xylene-based polymer, a vinyl alcohol-based polymer, or a combination thereof. In one or more embodiments, a third interlayer insulating layer may be further arranged under the planarization layer 118. The third interlayer insulating layer may include an inorganic insulating material, such as SiOₓ, SiNₓ, and/or SiOₓN_{y}.

A plurality of display elements may be arranged on the planarization layer 118. For example, the first display element DPE1, the second display element DPE2, and the third display element DPE3 may be spaced apart from each other on the planarization layer 118. For example, the first display element DPE1 and the second display element DPE2 may be arranged on the planarization layer 118 and spaced apart from each other in the first direction (e.g., the x-axis direction), and the third display element DPE3 may be arranged on the planarization layer 118 and positioned on the opposite side of the second display element DPE2 with the first display element DPE1 between the third display element DPE3 and the second display element DPE2.

The first display element DPE1 may include the first pixel electrode 211, the emission layer 220, and an opposite electrode 230. The second display element DPE2 may include the second pixel electrode 212, the emission layer 220, and the opposite electrode 230. The third display element DPE3 may include the third pixel electrode 213, the emission layer 220, and the opposite electrode 230. In other words, the first pixel electrode 211, the second pixel electrode 212, and the third pixel electrode 213 provided in the first display element DPE1, the second display element DPE2, and the third display element DPE3, respectively, may be patterned. Each of the emission layers 220 and the opposite electrodes 230 of the first display element DPE1, the second display element DPE2, and the third display element DPE3 may be integrally provided as one body across the first display element DPE1, the second display element DPE2, and the third display element DPE3. In some embodiments, the emission layers 220 and the opposite electrodes 230 of the first display element DPE1, the second display element DPE2, and the third display element DPE3 may be integrally provided across the entire surface of the substrate 100. The emission layer 220 may be arranged between the first pixel electrode 211, the second pixel electrode 212, and the third pixel electrode 213.

The first pixel electrode 211 and the second pixel electrode 212 and the third pixel electrode 213 may be arranged on the planarization layer 118 and spaced apart from each other. For example, the first pixel electrode 211 and the second pixel electrode 212 may be spaced apart from each other in the first direction (e.g., the x-axis direction) and arranged on the planarization layer 118, and the third pixel electrode 213 may be arranged on the planarization layer 118 and positioned in the opposite direction of the second pixel electrode 212 with the first pixel electrode 211 positioned between the third pixel electrode 213 and the second pixel electrode 212 (e.g., the second pixel electrode 212 and the third pixel electrode 213 may be opposite each other with the first pixel electrode 211 therebetween).

The first pixel electrode 211, the second pixel electrode 212, and the third pixel electrode 213 may include a light-transmitting conductive layer including a light-transmitting conductive oxide, such as indium tin oxide (ITO), indium oxide (In₂O₃), or indium zinc oxide (IZO), and a reflective layer including metal, such as Al or silver (Ag). For example, the first pixel electrode 211, the second pixel electrode 212, and the third pixel electrode 213 may have a three-layer structure of ITO/Ag/ITO.

The first pixel electrode 211, the second pixel electrode 212, and the third pixel electrode 213 may contact any of the source electrode SE and the drain electrode DE, and may be electrically connected to the transistor TFT, as shown in FIG. 5. For example, each of the first pixel electrode 211, the second pixel electrode 212, and the third pixel electrode 213 may contact any of the source electrode SE and the drain electrode DE through a contact hole defined in the planarization layer 118.

The emission layer 220 may be arranged on the first pixel electrode 211, the second pixel electrode 212, and the third pixel electrode 213. In other words, the emission layer 220 may be arranged across the first pixel electrode 211, the second pixel electrode 212, and the third pixel electrode 213. For example, the emission layer 220 may be integrally provided as one body, or as an integral unitary body, substantially across the entire surface of the substrate 100. Accordingly, the emission layer 220 may be integrally provided as one body across the first display element DPE1, the second display element DPE2, and the third display element DPE3. In other words, the emission layer 220 may be integrally provided as one body over the first pixel electrode 211, the second pixel electrode 212, and the third pixel electrode 213.

Accordingly, a portion of the emission layer 220 may be arranged on the first pixel electrode 211, the second pixel electrode 212, and the third pixel electrode 213 (as used herein, "portion" in the singular, and "portions" in the plural, may be interchanged as appropriate for the description). A portion(s) of the emission layer 220 may be arranged between the first pixel electrode 211 and the second pixel electrode 212, and between the first pixel electrode 211 and the third pixel electrode 213. In addition, a portion of the emission layer 220 may be arranged between the second pixel electrode 212 and the third pixel electrode 213. For example, a portion(s) of the emission layer 220 may be arranged on the planarization layer 118 between the first pixel electrode 211 and the second pixel electrode 212, and between the first pixel electrode 211 and the third pixel electrode 213. In other words, the emission layer 220 may cover the first pixel electrode 211, the second pixel electrode 212, and the third pixel electrode 213.

Because the emission layer 220 is integrally formed as one body over the first pixel electrode 211, the second pixel electrode 212, and the third pixel electrode 213, the emission layer 220 may have a substantially uniform thickness. For example, a portion of the emission layer 220 arranged on the first pixel electrode 211 may have a substantially uniform thickness. Similarly, a portion of the emission layer 220 arranged on the second pixel electrode 212 may have a substantially uniform thickness. Also, a portion of the emission layer 220 arranged on the third pixel electrode 213 may have a substantially uniform thickness.

Meanwhile, a thickness of a portion of the emission layer 220 arranged on the first pixel electrode 211 may be greater than a thickness of the first pixel electrode 211. Similarly, a thickness of a portion of the emission layer 220 arranged on the second pixel electrode 212 may be greater than a thickness of the second pixel electrode 212. Also, a thickness of a portion of the emission layer 220 arranged on the third pixel electrode 213 may be greater than a thickness of the third pixel electrode 213. For example, a thickness of each of the first pixel electrode 211, the second pixel electrode 212, and the third pixel electrode 213 may be about 100 nm, and a thickness of a portion of the emission layer 220 arranged on the first pixel electrode 211, the second pixel electrode 212, or the third pixel electrode 213 may be about 100 nm to about 500 nm.

The emission layer 220 may emit red light, green light, or blue light. The emission layer 220 may include an organic material, an inorganic material, or quantum dots. In some embodiments, the emission layer 220 may include an organic material and quantum dots, or may include an inorganic material and quantum dots. For example, the emission layer 220 may include a polymer or low-molecular weight organic material capable of emitting light of a certain color (red, green, and blue). For example, the emission layer 220 may include a polymer material based on polyphenylene vinylene (PPV) or polyfluorene. Such an emission layer 220 may be formed by using a method such as spin coating, slit coating, or inkjet printing. However, other embodiments are not limited thereto.

In one or more embodiments, a functional layer may be arranged below and/or over the emission layer 220. The functional layer may include a hole injection layer (HIL), a hole transport layer (HTL), an electron transport layer (ETL), and/or an electron injection layer (EIL). Such a functional layer may be integrally provided as one body across the first pixel electrode 211, the second pixel electrode 212, and the third pixel electrode 213. In addition, similar to the emission layer 220, the functional layer may be formed by using a method, such as spin coating, slit coating, or inkjet printing, and the film thickness substantial uniformity achieved by the disclosure may be ensured as in the case of the emission layer 220.

The opposite electrode 230 may be arranged on the emission layer 220. The opposite electrode 230 may be integrally provided as one body across the entire surface of the substrate 100. Accordingly, the opposite electrode 230 may be integrally provided as one body across the first display element DPE1, the second display element DPE2, and the third display element DPE3. In other words, the opposite electrode 230 may be integrally provided as one body over the first pixel electrode 211, the second pixel electrode 212, and the third pixel electrode 213. Accordingly, the opposite electrode 230 may be arranged on the first pixel electrode 211, the second pixel electrode 212, and the third pixel electrode 213. Also, the emission layer 220 may be arranged between the first pixel electrode 211 and the opposite electrode 230, between the second pixel electrode 212 and the opposite electrode 230, and between the third pixel electrode 213 and the opposite electrode 230.

The opposite electrode 230 may include a light-transmitting conductive layer including ITO, In₂O₃, or IZO, and may include a semi-transmissive film including metal, such as Al or Ag. For example, the opposite electrode 230 may be a semi-transmissive film including magnesium (Mg) or Ag.

The pixel-defining layer 119 may be positioned between the emission layer 220 and the opposite electrode 230. As described above, the pixel-defining layer 119 may define the first pixel opening OP11, the second pixel opening OP12, and the third pixel opening OP13. When viewed from a direction perpendicular to the substrate 100 (e.g., in plan view), the first pixel opening OP11 may overlap the first pixel electrode 211. When viewed from the direction perpendicular to the substrate 100, the second pixel opening OP12 may overlap the second pixel electrode 212, and the third pixel opening OP13 may overlap the third pixel electrode 213.

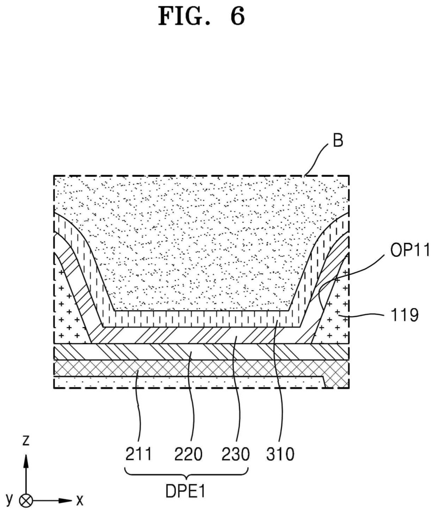

Accordingly, as shown in FIG. 6, which is a cross-sectional view schematically showing enlarged region B of the display apparatus 1 of FIG. 5, a portion of the emission layer 220 may be arranged between a portion of the pixel-defining layer 119 adjacent to the first pixel opening OP11 and a portion of the first pixel electrode 211, and another portion of the emission layer 220 may be arranged between a portion of the opposite electrode 230 overlapping the first pixel opening OP11 and another portion of the first pixel electrode 211.

Similarly, a portion of the emission layer 220 may be arranged between a portion of the pixel-defining layer 119 adjacent to the second pixel opening OP12 and a portion of the second pixel electrode 212, and another portion of the emission layer 220 may be arranged between a portion of the opposite electrode 230 overlapping the second pixel opening OP12 and another portion of the second pixel electrode 212. Also, a portion of the emission layer 220 may be arranged between a portion of the pixel-defining layer 119 adjacent to the third pixel opening OP13 and a portion of the third pixel electrode 213, and another portion of the emission layer 220 may be arranged between a portion of the opposite electrode 230 overlapping the third pixel opening OP13 and another portion of the third pixel electrode 213.

The pixel-defining layer 119 may define a pixel by defining an opening corresponding to a pixel (e.g., an opening that exposes the emission layer 220 arranged on at least a central portion of a pixel electrode). In addition, the pixel-defining layer 119 may increase a distance between an edge of the pixel electrode and the opposite electrode 230 that is on the pixel electrode. Thereby, the likelihood of destruction of a display element, such as a short-circuiting caused by electric field concentration, at the edge of the pixel electrode may be reduced or prevented. Such a pixel-defining layer 119 may include an organic material, such as polyimide or HMDSO.

An encapsulation layer 300 may be arranged on the first display element DPE1, the second display element DPE2, and the third display element DPE3. For example, the encapsulation layer 300 may be arranged on the opposite electrode 230. In other words, because the display elements DPE1, DPE2, and DPE3 may be damaged by moisture or oxygen from the outside, the encapsulation layer 300 may cover and protect the first display element DPE1, the second display element DPE2, and the third display element DPE3.

The encapsulation layer 300 may include at least one inorganic layer and at least one organic layer. For example, as shown in FIG. 5, the encapsulation layer 300 may include a first inorganic encapsulation layer 310, an organic encapsulation layer 320, and a second inorganic encapsulation layer 330. For example, the encapsulation layer 300 including the first inorganic encapsulation layer 310, the second inorganic encapsulation layer 330, and the organic encapsulation layer 320 between the first inorganic encapsulation layer 310 and the second inorganic encapsulation layer 330 may be arranged on the opposite electrode 230.

The first inorganic encapsulation layer 310 may cover the opposite electrode 230 and may include SiOₓ, SiNₓ, and/or SiOₓN_{y}. Because the first inorganic encapsulation layer 310 may be formed along a structure under the first inorganic encapsulation layer 310, an upper surface of the first inorganic encapsulation layer 310 may not be flat, as shown in FIG. 5. The organic encapsulation layer 320 may cover this first inorganic encapsulation layer 310, but an upper surface of the organic encapsulation layer 320 may be approximately flat, unlike the first inorganic encapsulation layer 310.

Such an organic encapsulation layer 320 may include one or more materials selected from the group consisting of polyethylene terephthalate, polyethylene naphthalate, polycarbonate, polyimide, polyethylene sulfonate, polyoxymethylene, polyarylate, and/or HMDSO. The second inorganic encapsulation layer 330 may cover the organic encapsulation layer 320 and may include SiOₓ, SiNₓ, and/or SiOₓN_{y}.

As described above, the encapsulation layer 300 includes the first inorganic encapsulation layer 310, the organic encapsulation layer 320, and the second inorganic encapsulation layer 330. Thus, even if cracks should occur in the encapsulation layer 300 through such a multi-layer structure, such cracks may not be connected between, or may not extend between, the first inorganic encapsulation layer 310 and the organic encapsulation layer 320 or between the organic encapsulation layer 320 and the second inorganic encapsulation layer 330. Therefore, the formation of a path through which external moisture or oxygen permeates into the display apparatus 1 may be prevented, reduced, or minimized.

A light-shielding wall portion 410, a first color conversion layer 451, a second color conversion layer 452, and a light-transmissive layer 453 may be arranged on the encapsulation layer 300. The first color conversion layer 451, the second color conversion layer 452, and the light-transmissive layer 453 may transmit light emitted from display elements, or may convert light emitted from display elements into light of a corresponding color. The light that is transmitted by, or of which a color has been converted by, the first color conversion layer 451, the second color conversion layer 452, or the light-transmissive layer 453 may be one of green light, red light, or blue light. The first color conversion layer 451, the second color conversion layer 452, and the light-transmissive layer 453 may be spaced apart by certain intervals, and the light-shielding wall portion 410 may be positioned between the first color conversion layer 451, the second color conversion layer 452, and the light-transmissive layer 453. Thereby, the light-shielding wall portion 410 may reduce or prevent color mixing from occurring between light converted or transmitted in the first color conversion layer 451, the second color conversion layer 452, and the light-transmissive layer 453.

The light-shielding wall portion 410 may define a first color conversion opening OP21, a second color conversion opening OP22, and a third color conversion opening OP23 (e.g., a light-transmissive opening). The first color conversion opening OP21 may overlap the first pixel opening OP11, the second color conversion opening OP22 may overlap the second pixel opening OP12, and the third color conversion opening/light-transmissive opening OP23 may overlap the third pixel opening OP13. Thereby, the first color conversion opening OP21 may correspond to the first display element DPE1, the second color conversion opening OP22 may correspond to the second display element DPE2, and the third color conversion opening/light-transmissive opening OP23 may correspond to the third display element DPE3.

The light-shielding wall portion 410 may be provided in various colors, such as black, white, red, purple, or blue. The light-shielding wall portion 410 may include a colored pigment or dye. The light-shielding wall portion 410 may include a light-shielding material, and the light-shielding material may include an opaque inorganic insulating material including metal oxide, such as titanium oxide (TiO₂), chrome oxide (Cr₂O₃), or molybdenum oxide (MoO₃), or may include an opaque organic insulating material, such as black resin. In another example, the light-shielding wall portion 410 may include an organic insulating material, such as white resin.

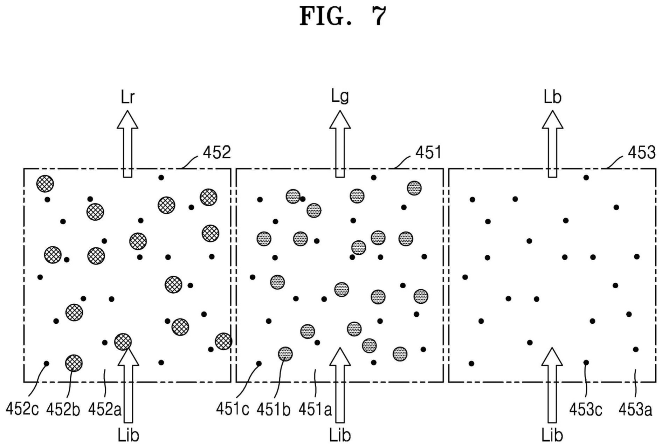

The first color conversion layer 451 may be arranged in the first color conversion opening OP21, the second color conversion layer 452 may be arranged in the second color conversion opening OP22, and the light-transmissive layer 453 may be arranged in the third color conversion opening OP23 (e.g., light-transmissive opening). As shown in FIG. 7, which is a diagram for describing the first color conversion layer 451, the second color conversion layer 452, and the light-transmissive layer 453 included in the display apparatus 1, according to one or more embodiments, incident light Lib may be incident on the first color conversion layer 451, the second color conversion layer 452, and the light-transmissive layer 453. The incident light Lib may be light emitted by the first display element DPE1, the second display element DPE2, and the third display element DPE3. For example, the incident light Lib may be blue light having a wavelength band of about 400 nm to about 495 nm. The incident light Lib emitted from the display elements may be transmitted or converted into green light, red light, and blue light while passing through the first color conversion layer 451, the second color conversion layer 452, or the light-transmissive layer 453, so that the display apparatus 1 may generate a color image.

For example, the first color conversion layer 451 may convert blue incident light Lib into green light Lg. To this end, the first color conversion layer 451 may include a first photosensitive polymer 451a in which first quantum dots 451b are dispersed.

The first photosensitive polymer 451a may be an organic material having light transmittance, such as silicon resin or epoxy resin. The first quantum dots 451b may be excited by the blue incident light Lib so that the green light Lg having a greater wavelength than blue light is isotropically emitted. The first quantum dots 451b may include a Group II-VI compound, a Group III-V compound, a Group IV-VI compound, a Group IV compound, or a combination thereof.

First scattering particles 451c may be further dispersed in the first photosensitive polymer 451a. The first scattering particles 451c may scatter the blue incident light Lib not absorbed by the first quantum dots 451b so as to excite more first quantum dots 451b, thereby increasing color conversion efficiency of the first color conversion layer 451. The first scattering particles 451c may be, for example, TiO₂ or metal particles.

The second color conversion layer 452 may convert the blue incident light Lib into red light Lr. The second color conversion layer 452 may include a second photosensitive polymer 452a in which second quantum dots 452b are dispersed, and second scattering particles 452c may be dispersed together with the second quantum dots 452b in the second photosensitive polymer 452a so that color conversion efficiency of the second color conversion layer 452 may be increased.

The second photosensitive polymer 452a may include a same material as the first photosensitive polymer 451a, and the second scattering particles 452c may include a same material as the first scattering particles 451c. The second quantum dots 452b may include a Group II-VI compound, a Group III-V compound, a Group IV-VI compound, a Group IV compound, or a combination thereof. In other words, the second quantum dots 452b may be a same material as the first quantum dots 451b. However, the second quantum dots 452b may be greater in size from the first quantum dots 451b. Thus, the second quantum dots 452b may be excited by the blue incident light Lib, and may isotropically emit the red light Lr having a greater wavelength than the green light Lg and a greater wavelength than the blue light Lb.

The light-transmissive layer 453 may include a third photosensitive polymer 453a in which third scattering particles 453c are dispersed. In other words, the light-transmissive layer 453 may omit an additional quantum dot that may be excited by the blue incident light Lib. Meanwhile, the third photosensitive polymer 453a may include an organic material having light transmittance, similar to the first photosensitive polymer 451a, and the third scattering particles 453c may include a same material as the first scattering particles 451c. Thus, the blue incident light Lib incident on the light-transmissive layer 453 may pass through the light-transmissive layer 453 without color change, and thus, light emitted through the light-transmissive layer 453 may be blue light Lb. However, the blue incident light Lib may be scattered by the third scattering particles 453c within the light-transmissive layer 453, and may be emitted to the outside. The light-transmissive layer 453 may transmit the blue incident light Lib incident thereon, without color change, thereby obtaining higher light efficiency.

A capping layer 470 may be arranged on the first color conversion layer 451, the second color conversion layer 452, and the light-transmissive layer 453. Accordingly, the first color conversion layer 451, the second color conversion layer 452, and the light-transmissive layer 453 may be positioned between the encapsulation layer 300 and the capping layer 470. The capping layer 470 may cover the first color conversion layer 451, the second color conversion layer 452, and the light-transmissive layer 453. The capping layer 470 may include an inorganic material, such as SiOₓ, SiNₓ, and/or SiOₓN_{y}.

Quantum dots included in each of the first color conversion layer 451 and the second color conversion layer 452 include nanoparticles, and thus may be deteriorated by reacting with moisture or oxygen. The encapsulation layer 300 and the capping layer 470 may cover the first color conversion layer 451 and the second color conversion layer 452 by being respectively under and above the first color conversion layer 451 and the second color conversion layer 452 so that little to no moisture or oxygen permeates into the quantum dots in the first color conversion layer 451 and the second color conversion layer 452.

In FIG. 5, display elements and color conversion layers of the display apparatus 1 are formed on one substrate. However, other embodiments are not limited thereto. For example, the display elements and the encapsulation layer 300 may be formed on a lower substrate, the color conversion layers and the light-shielding wall portion 410 may be formed on an upper substrate. Then, the lower substrate and the upper substrate may be attached to each other to constitute the display apparatus 1.

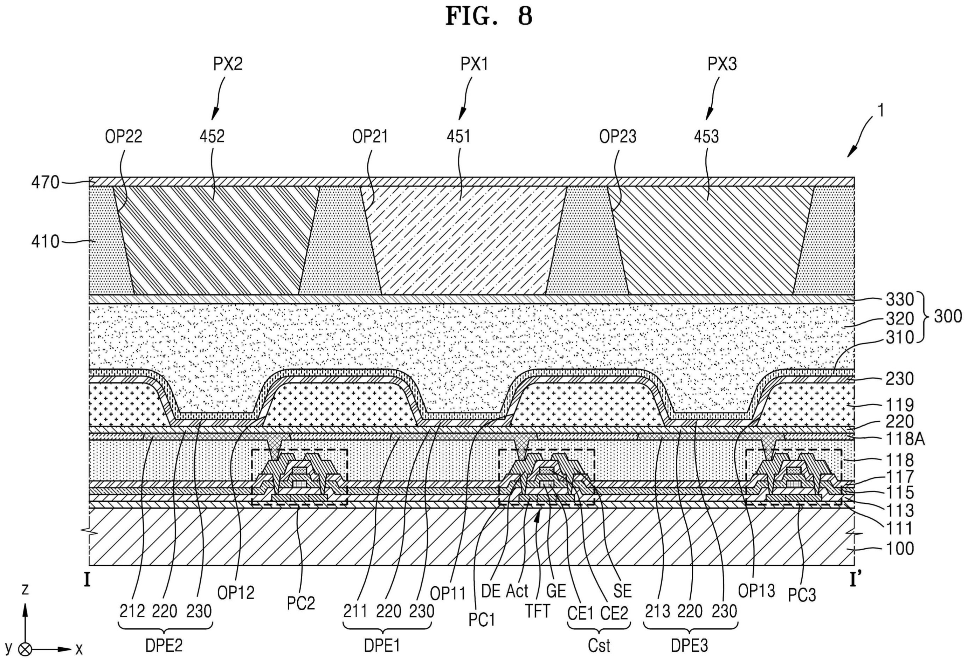

FIG. 8 is a cross-sectional view schematically illustrating the display apparatus 1 according to one or more embodiments. The display apparatus 1 is similar to that described above with reference to FIGS. 1 to 7, and thus, descriptions below are mainly focused on differences from the display apparatus 1 described above with reference to FIGS. 1 to 7. In FIG. 8, same reference characters as those of FIGS. 1 to 7 denote a same member, and redundant descriptions thereof are omitted.

In the display apparatus 1 corresponding to FIGS. 1 to 7, a portion(s) of the emission layer 220 may be arranged between the first pixel electrode 211 and the second pixel electrode 212, and between the first pixel electrode 211 and the third pixel electrode 213. For example, a portion(s) of the emission layer 220 may be arranged on the planarization layer 118 between the first pixel electrode 211 and the second pixel electrode 212, and between the first pixel electrode 211 and the third pixel electrode 213. Also in the display apparatus 1, a portion(s) of the emission layer 220 may be arranged between the first pixel electrode 211 and the second pixel electrode 212, and between the first pixel electrode 211 and the third pixel electrode 213.

In the display apparatus 1 corresponding to FIGS. 1 to 7, the portion(s) of the emission layer 220 arranged between the first pixel electrode 211 and the second pixel electrode 212 and between the first pixel electrode 211 and the third pixel electrode 213 may directly contact the planarization layer 118.

However, as shown in FIG. 8, in the display apparatus 1, the portion(s) of the emission layer 220 arranged between the first pixel electrode 211 and the second pixel electrode 212 and between the first pixel electrode 211 and the third pixel electrode 213 may not be in direct contact with (e.g., may be spaced apart from) the planarization layer 118.

For example, as shown in FIG. 8, the display apparatus 1 may include a planarization auxiliary layer 118A. The planarization auxiliary layer 118A may be arranged on the planarization layer 118, and may be between the first pixel electrode 211 and the second pixel electrode 212 and between the first pixel electrode 211 and the third pixel electrode 213, and may directly contact the planarization layer 118. In this case, the portion(s) of the emission layer 220 arranged between the first pixel electrode 211 and the second pixel electrode 212 and between the first pixel electrode 211 and the third pixel electrode 213 (e.g., in plan view) may directly contact the planarization auxiliary layer 118A. In other words, the planarization auxiliary layer 118A may be positioned between (e.g., directly between) the planarization layer 118 and the emission layer 220.

An upper surface of such a planarization auxiliary layer 118A may form a flat surface with (e.g., may be substantially coplanar with) an upper surface of the first pixel electrode 211, an upper surface of the second pixel electrode 212, and an upper surface of the third pixel electrode 213. In other words, the upper surface of the planarization auxiliary layer 118A, the upper surface of the first pixel electrode 211, the upper surface of the second pixel electrode 212, and the upper surface of the third pixel electrode 213 may form a flat surface (e.g., may be substantially coplanar). Thus, the emission layer 220 integrally formed as one body over the first pixel electrode 211, the second pixel electrode 212, and the third pixel electrode 213 may have a substantially uniform thickness.

Meanwhile, the planarization auxiliary layer 118A may include a same material as the planarization layer 118. For example, the planarization auxiliary layer 118A may include an organic insulating material. For example, the planarization auxiliary layer 118A may include a photoresist, BCB, polyimide, HMDSO, PMMA, polystyrene, a polymer derivative having a phenol-based group, an acryl-based polymer, an imide-based polymer, aryl ether-based polymer, an amide-based polymer, a fluorine-based polymer, a p-xylene-based polymer, a vinyl alcohol-based polymer, or a combination thereof.

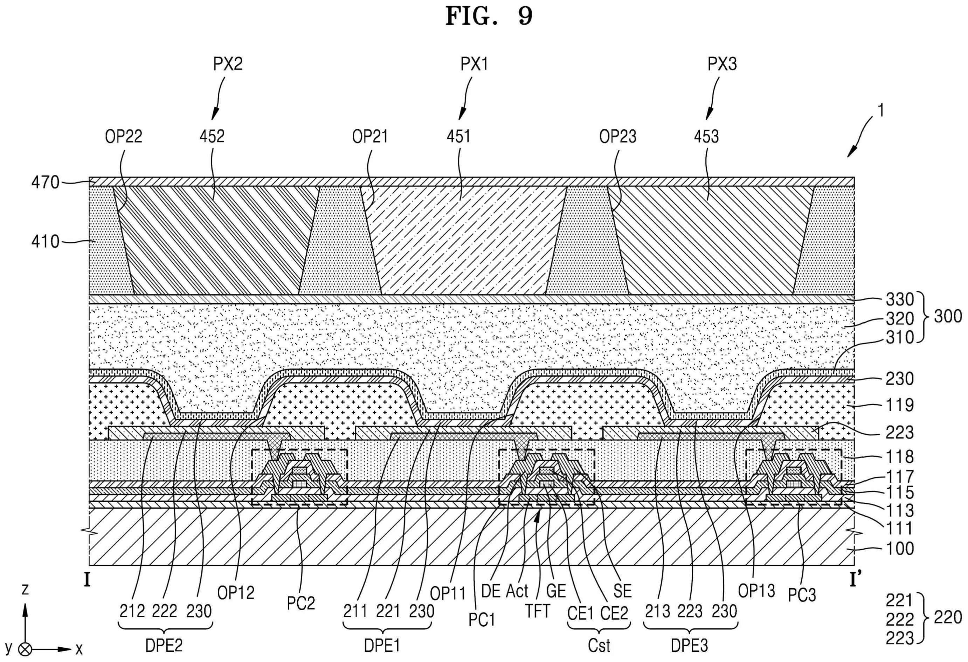

FIG. 9 is a cross-sectional view schematically illustrating the display apparatus 1 according to one or more embodiments. The display apparatus 1 is similar to that described above with reference to FIGS. 1 to 7, and thus, descriptions below are mainly focused on differences from the display apparatus 1 described above with reference to FIGS. 1 to 7. In FIG. 9, same reference characters as those of FIGS. 1 to 7 denote a same member, and redundant descriptions thereof are omitted.

In the display apparatus 1 described above with reference to FIGS. 1 to 7, a portion(s) of the emission layer 220 may be arranged on the planarization layer 118 between the first pixel electrode 211 and the second pixel electrode 212 and between the first pixel electrode 211 and the third pixel electrode 213. Also in the display apparatus 1, a portion of the emission layer 220 may be arranged on the planarization layer 118 between the first pixel electrode 211 and the second pixel electrode 212 and between the first pixel electrode 211 and the third pixel electrode 213.

In the display apparatus 1 described above with reference to FIGS. 1 to 7, the emission layer 220 may be integrally provided as one body across the entire surface of the substrate 100.

However, as shown in FIG. 9, in the display apparatus 1, the emission layer 220 may not be integrally provided as one body across the entire surface of the substrate 100. In other words, the emission layer 220 may be arranged only on a portion(s) of the planarization layer 118 arranged on the substrate 100. For example, the emission layer 220 may include a plurality of sub-emission layers. The plurality of sub-emission layers may be arranged on the planarization layer 118, and may be spaced apart from each other.

For example, the emission layer 220 may include a first emission layer 221, a second emission layer 222, and a third emission layer 223. The first emission layer 221, the second emission layer 222, and the third emission layer 223 may be arranged on the planarization layer 118, and may be spaced apart from each other. The first emission layer 221 may be arranged between the first pixel electrode 211 and the opposite electrode 230, the second emission layer 222 may be arranged between the second pixel electrode 212 and the opposite electrode 230, and the third emission layer 223 may be arranged between the third pixel electrode 213 and the opposite electrode 230.

In this case, the portion of the pixel-defining layer 119 arranged between the first pixel electrode 211 and the second pixel electrode 212 and between the first pixel electrode 211 and the third pixel electrode 213 may directly contact the planarization layer 118. For example, the portion of the pixel-defining layer 119 arranged on the planarization layer 118 between the first pixel electrode 211 and the second pixel electrode 212 and between the first pixel electrode 211 and the third pixel electrode 213 may directly contact the planarization layer 118. Also in this case, a portion of the first emission layer 221 may be arranged between a portion of the pixel-defining layer 119 adjacent to the first pixel opening OP11 and a portion of the first pixel electrode 211, and another portion of the first emission layer 221 may be arranged between a portion of the opposite electrode 230 overlapping the first pixel opening OP11 and another portion of the first pixel electrode 211.

Similarly, a portion of the second emission layer 222 may be arranged between a portion of the pixel-defining layer 119 adjacent to the second pixel opening OP12 and a portion of the second pixel electrode 212, and another portion of the second emission layer 222 may be arranged between a portion of the opposite electrode 230 overlapping the second pixel opening OP12 and another portion of the second pixel electrode 212. Also, a portion of the third emission layer 223 may be arranged between a portion of the pixel-defining layer 119 adjacent to the third pixel opening OP13 and a portion of the third pixel electrode 213, and another portion of the third emission layer 223 may be arranged between a portion of the opposite electrode 230 overlapping the third pixel opening OP13 and another portion of the third pixel electrode 213.

In general, when any one layer is commonly provided across a plurality of display elements, leakage current may flow between the plurality of display elements through that layer. In this case, display quality of the display apparatus may be deteriorated, and for example, color purity of the display apparatus may be lowered. However, in the display apparatus 1, a portion of the emission layer 220 included in the first display element DPE1, a portion of the emission layer 220 included in the second display element DPE2, and a portion of the emission layer 220 included in the third display element DPE3 may be spaced apart from each other. In other words, the portion of the emission layer 220 included in the first display element DPE1, the portion of the emission layer 220 included in the second display element DPE2, and the portion of the emission layer 220 included in the third display element DPE3 may be disconnected from each other. Thus, an amount of leakage current flowing between the display elements through the emission layer 220 may be reduced or eliminated. Therefore, the display apparatus 1 may not be degraded in display quality.

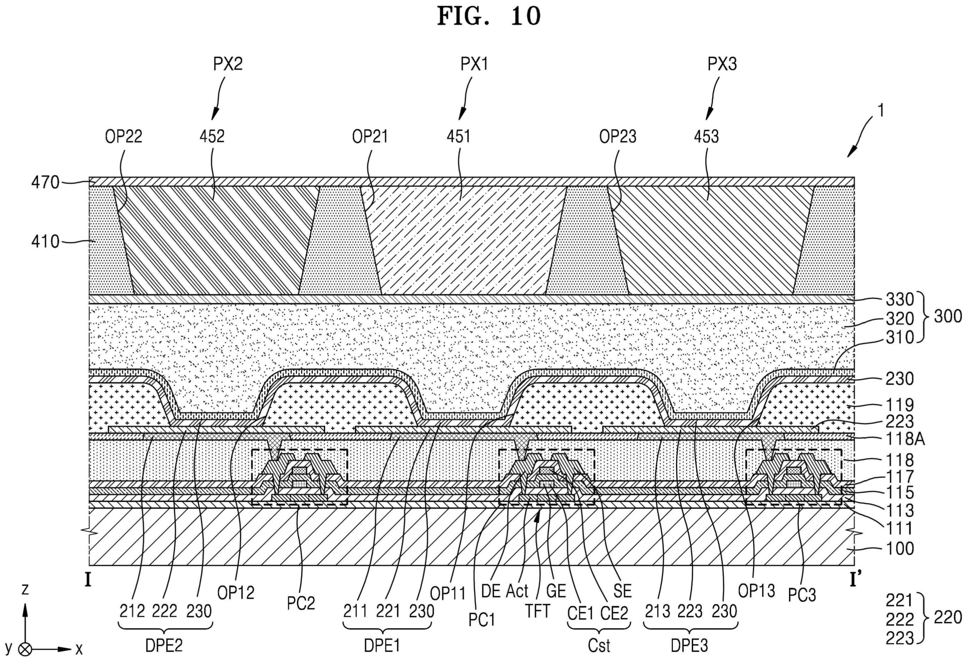

FIG. 10 is a cross-sectional view schematically illustrating the display apparatus 1 according to one or more embodiments. The display apparatus 1 is similar to that described above with reference to FIG. 8, and thus, descriptions below are mainly focused on differences from the display apparatus 1 described above with reference to FIG. 8. In FIG. 10, same reference characters as those of FIG. 8 denote a same member, and redundant descriptions thereof are omitted.

In the display apparatus 1 described above with reference to FIG. 8, the display apparatus 1 may include the planarization auxiliary layer 118A. In the display apparatus 1 described above with reference to FIG. 8, an upper surface of the planarization auxiliary layer 118A, an upper surface of the first pixel electrode 211, an upper surface of the second pixel electrode 212, and an upper surface of the third pixel electrode 213 may form a flat surface, and the planarization auxiliary layer 118A may include a same material as the planarization layer 118. Also, the display apparatus 1 may include the planarization auxiliary layer 118A. In the display apparatus 1, the upper surface of the planarization auxiliary layer 118A, the upper surface of the first pixel electrode 211, the upper surface of the second pixel electrode 212, and the upper surface of the third pixel electrode 213 may form a flat surface, and the planarization auxiliary layer 118A may include a same material as the planarization layer 118.

In the display apparatus 1 described above with reference to FIG. 8, the emission layer 220 may be integrally provided as one body across the entire surface of the substrate 100.

However, as shown in FIG. 10, in the display apparatus 1, the emission layer 220 may not be integrally provided as one body across the entire surface of the substrate 100. In other words, the emission layer 220 may be arranged only on a portion of the planarization layer 118 arranged over the substrate 100. For example, the emission layer 220 may include a plurality of sub-emission layers. The plurality of sub-emission layers may be arranged on the planarization layer 118, and may be spaced apart from each other.

For example, the emission layer 220 may include the first emission layer 221, the second emission layer 222, and the third emission layer 223. The first emission layer 221, the second emission layer 222, and the third emission layer 223 may be arranged on the planarization layer 118, and may be spaced apart from each other. The first emission layer 221 may be arranged between the first pixel electrode 211 and the opposite electrode 230, the second emission layer 222 may be arranged between the second pixel electrode 212 and the opposite electrode 230, and the third emission layer 223 may be arranged between the third pixel electrode 213 and the opposite electrode 230.

In this case, the portion(s) of the pixel-defining layer 119 arranged between the first pixel electrode 211 and the second pixel electrode 212 and between the first pixel electrode 211 and the third pixel electrode 213 may directly contact the planarization auxiliary layer 118A. For example, the portion(s) of the pixel-defining layer 119 arranged on (e.g., above) the planarization layer 118 between the first pixel electrode 211 and the second pixel electrode 212 and between the first pixel electrode 211 and the third pixel electrode 213 may directly contact the planarization auxiliary layer 118A. Also in this case, a portion of the first emission layer 221 may be arranged between a portion of the pixel-defining layer 119 adjacent to the first pixel opening OP11 and a portion of the first pixel electrode 211, and another portion of the first emission layer 221 may be arranged between a portion of the opposite electrode 230 overlapping the first pixel opening OP11 and another portion of the first pixel electrode 211.

Similarly, a portion of the second emission layer 222 may be arranged between a portion of the pixel-defining layer 119 adjacent to the second pixel opening OP12 and a portion of the second pixel electrode 212, and another portion of the second emission layer 222 may be arranged between a portion of the opposite electrode 230 overlapping the second pixel opening OP12 and another portion of the second pixel electrode 212. Also, a portion of the third emission layer 223 may be arranged between a portion of the pixel-defining layer 119 adjacent to the third pixel opening OP13 and a portion of the third pixel electrode 213, and another portion of the third emission layer 223 may be arranged between a portion of the opposite electrode 230 overlapping the third pixel opening OP13 and another portion of the third pixel electrode 213.

Similar to the display apparatus 1 described above with reference to FIG. 9, a portion of the emission layer 220 included in the first display element DPE1, a portion of the emission layer 220 included in the second display element DPE2, and a portion of the emission layer 220 included in the third display element DPE3 may be disconnected from each other. Thus, the amount of leakage current flowing between the display elements through the emission layer 220 may be reduced or eliminated. Therefore, the display apparatus 1 may not be degraded in display quality, either.

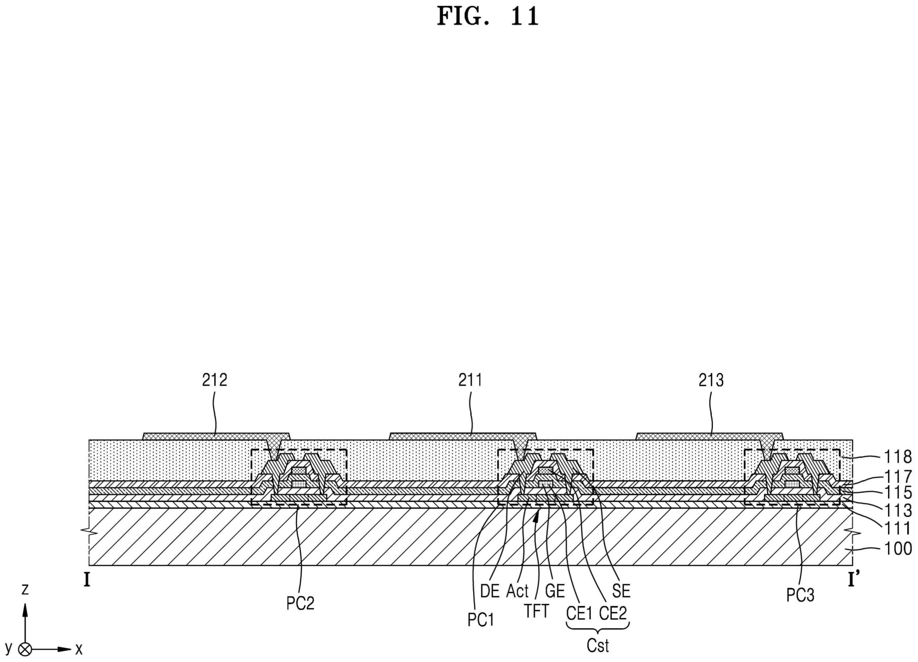

FIGS. 11 to 15 are cross-sectional views schematically illustrating a portion of a process of manufacturing the display apparatus 1 of FIG. 5. For example, FIGS. 11 to 15 are cross-sectional views schematically illustrating a process of forming the pixel electrodes, the emission layer 220, the pixel-defining layer 119, and the opposite electrode 230 of the display apparatus 1 of FIG. 5. For convenience of description, in FIGS. 11 to 15, a portion of a process of manufacturing the display apparatus 1 of FIG. 5 is described based on a cross-section of the display apparatus 1 of FIG. 4, taken along the line I-I'.

First, as shown in FIG. 11, the first pixel electrode 211 may be formed on the planarization layer 118. Along with the above, the second pixel electrode 212 and the third pixel electrode 213 may be formed on the planarization layer 118. For example, the second pixel electrode 212 may be formed on the planarization layer 118 to be spaced apart from the first pixel electrode 211 in the first direction (e.g., along the x-axis direction). The third pixel electrode 213 may be formed on the planarization layer 118, and may be positioned in the opposite direction of the second pixel electrode 212 with the first pixel electrode 211 between the third pixel electrode 213 and the second pixel electrode 212 (e.g., the second and third pixel electrodes 212 and 213 may be opposite each other with the first pixel electrode 211 therebetween). In other words, the first pixel electrode 211, the second pixel electrode 212, and the third pixel electrode 213 may be formed on the planarization layer 118.

Meanwhile, the planarization layer 118 may be formed on the substrate 100. Before the planarization layer 118 is formed on the substrate 100, the pixel circuit PC may be formed on the substrate 100. For example, the buffer layer 111 may be formed on the substrate 100, the semiconductor layer Act may be formed on the buffer layer 111, the gate-insulating layer 113 may be formed on the semiconductor layer Act, and the gate electrode GE may be formed on the gate-insulating layer 113. The gate electrode GE may be the first capacitor electrode CE1 of the storage capacitor Cst. Next, the first interlayer insulating layer 115 may be formed on the gate electrode GE, and the second capacitor electrode CE2 may be formed on the first interlayer insulating layer 115. Next, a second interlayer insulating layer 117 may be formed on the second capacitor electrode CE2. Next, the source electrode SE and the drain electrode DE may be formed on the second interlayer insulating layer 117, and the planarization layer 118 may be formed on the source electrode SE and the drain electrode DE. Such formation of the planarization layer 118 and the pixel circuit PC may be performed through a photo process or the like, and detailed descriptions related thereto are omitted.

Next, in one or more embodiments, contact holes may be defined in the planarization layer 118 so that each of the first pixel electrode 211, the second pixel electrode 212, and the third pixel electrode 213 may come into contact with any one of the source electrode SE or the drain electrode DE, and then a preliminary pixel electrode layer may be formed on the planarization layer 118 to correspond to the entire surface of the substrate 100. The first pixel electrode 211, the second pixel electrode 212, and the third pixel electrode 213 may be formed by patterning such a preliminary pixel electrode layer. In other words, the first pixel electrode 211, the second pixel electrode 212, and the third pixel electrode 213 may be formed on the planarization layer 118 formed on the substrate 100.

The first pixel electrode 211, the second pixel electrode 212, and the third pixel electrode 213 may include a light-transmitting conductive layer including a light-transmitting conductive oxide, such as ITO, In₂O₃, or IZO, and a reflective layer including metal, such as Al or Ag. For example, the first pixel electrode 211, the second pixel electrode 212, and the third pixel electrode 213 may have a three-layer structure of ITO/Ag/ITO.

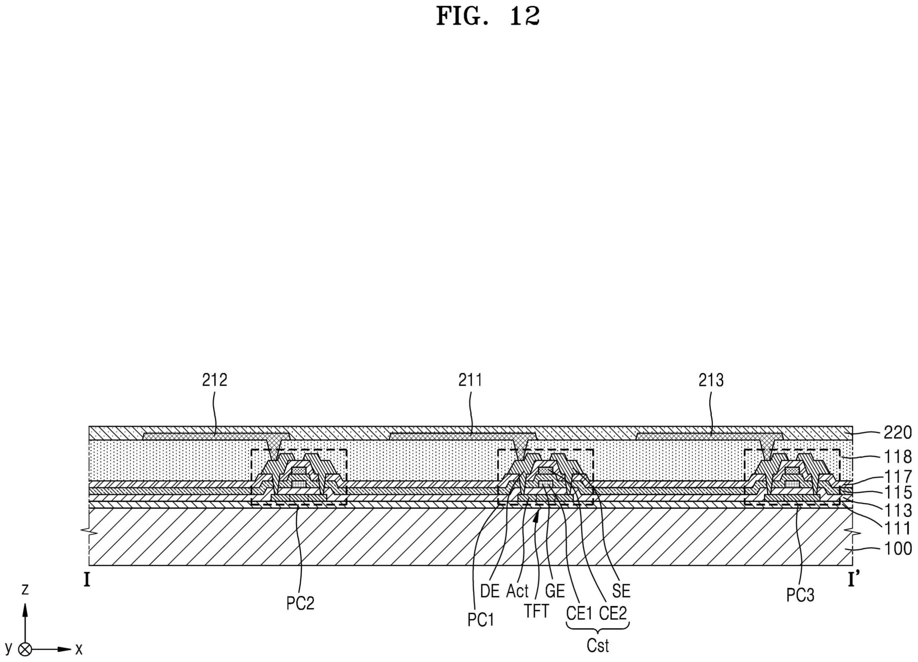

Next, as shown in FIG. 12, the emission layer 220 may be formed on the first pixel electrode 211. For example, the emission layer 220 may be integrally formed as one body across the first pixel electrode 211, the second pixel electrode 212, and the third pixel electrode 213. For example, the emission layer 220 may be formed on the entire surface of the substrate 100. Accordingly, a portion of the emission layer 220 may be formed on the first pixel electrode 211, the second pixel electrode 212, and the third pixel electrode 213, and a portion(s) of the emission layer 220 may also be formed between the first pixel electrode 211 and the second pixel electrode 212 and between the first pixel electrode 211 and the third pixel electrode 213. For example, a portion(s) of the emission layer 220 may be formed on the planarization layer 118 between the first pixel electrode 211 and the second pixel electrode 212 and between the first pixel electrode 211 and the third pixel electrode 213. In addition, a portion of the emission layer 220 may be formed between the second pixel electrode 212 and the third pixel electrode 213.

Such an emission layer 220 may include a polymer material based on PPV or polyfluorene. As described below, the pixel-defining layer 119 is formed on the emission layer 220, and thus a material included in the emission layer 220 may not dissolve in a solvent included in a pixel-defining layer forming material 119P. When functional layer HIL, HTL, ETL, EIL, or the like is arranged on the emission layer 220, a material included in the functional layer may not dissolve in the solvent included in the pixel-defining layer forming material 119P, similar to the material included in the emission layer 220.

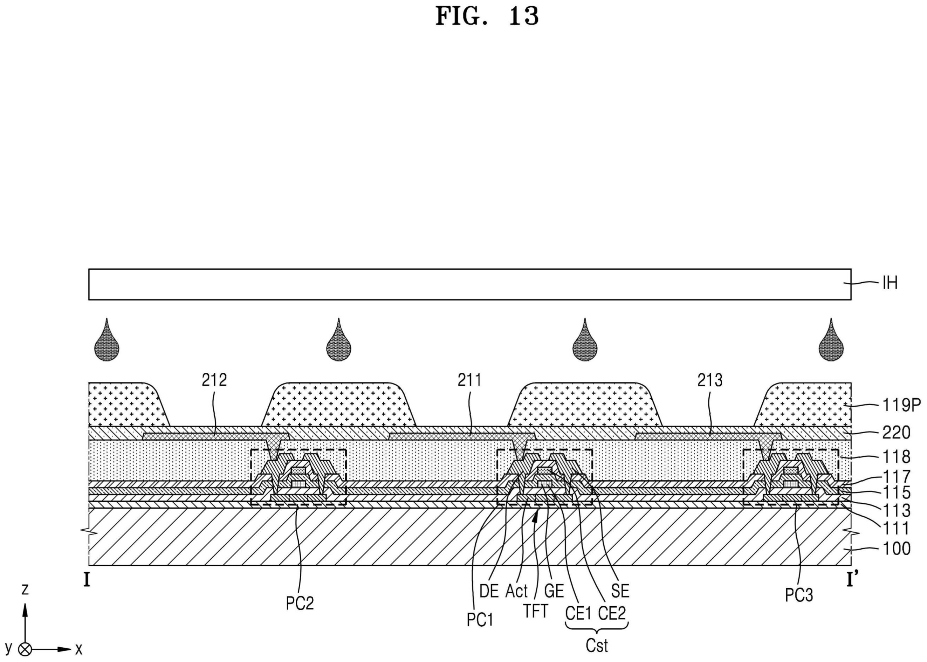

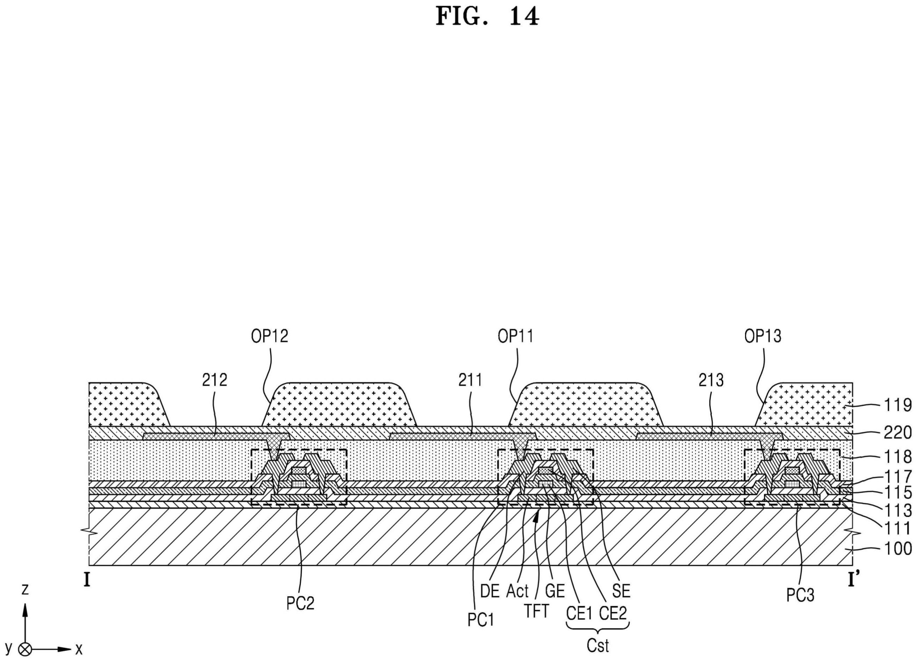

Next, as shown in FIGS. 13 and 14, the pixel-defining layer 119 may be formed on the emission layer 220. For example, as shown in FIG. 13, by using an inkjet printing method, the pixel-defining layer forming material 119P may be applied between the central portion of the first pixel electrode 211 and the central portion of the second pixel electrode 212 and between the central portion of the first pixel electrode 211 and the central portion of the third pixel electrode 213. In other words, by using the inkjet printing method, the pixel-defining layer forming material 119P may be applied onto the emission layer 220 between the central portion of the first pixel electrode 211 and the central portion of the second pixel electrode 212 and between the central portion of the first pixel electrode 211 and the central portion of the third pixel electrode 213.

The pixel-defining layer forming material 119P may be a solution prepared by mixing an organic material, such as polyimide or HMDSO, with a solvent. It may be suitable that the pixel-defining layer forming material 119P includes a material in which a crosslinking reaction may occur at a temperature that is lower than a temperature at which a material included in the emission layer 220 deteriorates. For example, the pixel-defining layer forming material 119P may be UPIA-LB2001 manufactured by UBE^{™} (UPIA^{™} and UBE^{™} being registered trademarks of UBE Corporation of JAPAN), Photoneece-LT manufactured by TORAY^{™} (PHOTONEECE^{™} and TORAY^{™} being registered trademarks of Toray Kabushiki Kaisha, a corporation of JAPAN) or ZEOCOAT-ZC100 manufactured by ZEON^{™} (ZEOCOAT^{™} and ZEON^{™} being a registered trademark of ZEON CORPORATION of JAPAN).

For example, an inkjet head IH including a plurality of nozzles may be used for inkjet printing. In other words, the plurality of nozzles included in the inkjet head IH may be arranged on the emission layer 220 between the first pixel electrode 211 and the second pixel electrode 212 and between the first pixel electrode 211 and the third pixel electrode 213. By using the plurality of nozzles of the inkjet head IH, the pixel-defining layer forming material 119P may be applied onto the emission layer 220 between the central portion of the first pixel electrode 211 and the central portion of the second pixel electrode 212 and between the central portion of the first pixel electrode 211 and the central portion of the third pixel electrode 213.

However, the plurality of nozzles included in the inkjet head IH may even be arranged on the emission layer 220 between the second pixel electrode 212 and the third pixel electrode 213, and the pixel-defining layer forming material 119P may be applied between the central portion of the second pixel electrode 212 and the central portion of the third pixel electrode 213 by using the plurality of nozzles of the inkjet head IH. In other words, the pixel-defining layer forming material 119P may be applied on the emission layer 220 except for portions of the emission layer 220 corresponding to the first pixel opening OP11, the second pixel opening OP12, and the third pixel opening OP13, respectively. However, a method of applying the pixel-defining layer forming material 119P of the disclosure is not limited to the inkjet printing method. For a method of applying the pixel-defining layer forming material 119P of the disclosure, any method that optionally applies the pixel-defining layer forming material 119P only at a position where the pixel-defining layer 119 is formed may be used.

Next, as shown in FIG. 14, the pixel-defining layer 119 may be formed by performing heat treatment on the pixel-defining layer forming material 119P. For example, the pixel-defining layer forming material 119P may be dried or heated. In some embodiments, the pixel-defining layer forming material 119P may be dried at a first temperature to remove a portion of the solvent included in the pixel-defining layer forming material 119P, and then the pixel-defining layer forming material 119P may be heated to a second temperature that is higher than the first temperature. For example, the pixel-defining layer forming material 119P may be dried at room temperature to remove a portion of the solvent included in the pixel-defining layer forming material 119P, and then the pixel-defining layer forming material 119P may be heat-treated by heating to about 100 °C to about 200 °C.

However, the heat treatment conditions of the pixel-defining layer forming material 119P are not necessarily limited thereto. Any heat treatment condition that is normally performed after an organic film forming material is applied so as to form an organic film may be used as a heat treatment condition of the pixel-defining layer forming material 119P. Thus, detailed descriptions related thereto are omitted. For example, when the pixel-defining layer forming material 119P is UPIA-LB2001 from UBE^{™}, the pixel-defining layer forming material 119P may be dried at room temperature and then heated to about 150 °C. When the pixel-defining layer forming material 119P is Photoneece-LT from TORAY^{™}, the pixel-defining layer forming material 119P may be dried at room temperature and then heated to about 170 °C. When the pixel-defining layer forming material 119P is ZEOCOAT-ZC100 from ZEON^{™}, the pixel-defining layer forming material 119P may be dried at room temperature and then heated to about 180 °C.

The pixel-defining layer forming material 119P forming the pixel-defining layer 119 is applied on the emission layer 220 between the central portion of the first pixel electrode 211 and the central portion of the second pixel electrode 212, between the central portion of the first pixel electrode 211 and the central portion of the third pixel electrode 213, and between the central portion of the second pixel electrode 212 and the central portion of the third pixel electrode 213, and thus the pixel-defining layer 119 may define the first pixel opening OP11, the second pixel opening OP12, and the third pixel opening OP13. In a plan view, the first pixel opening OP11 may overlap the first pixel electrode 211. Accordingly, a portion of the emission layer 220 may be arranged between a portion of the pixel-defining layer 119 adjacent to the first pixel opening OP11 and a portion of the first pixel electrode 211. Meanwhile, in a plan view, the second pixel opening OP12 may overlap the second pixel electrode 212, and the third pixel opening OP13 may overlap the third pixel electrode 213.

In general, a pixel opening is formed through a photo process or the like after applying a pixel-defining layer forming material onto the entire surface of a substrate and performing heat treatment on the pixel-defining layer forming material, thereby forming a pixel-defining layer. However, when an emission layer is formed before the pixel-defining layer is formed, the emission layer arranged under the pixel-defining layer forming material may be damaged in a process of applying the pixel-defining layer forming material onto the entire surface of the substrate and performing the photo process. However, in the method of manufacturing a display apparatus, the pixel-defining layer forming material 119P is applied only onto the emission layer 220 except for portions corresponding to the first pixel opening OP11, the second pixel opening OP12, and the third pixel opening OP13, and thus a photo process for defining a pixel opening in the pixel-defining layer 119 may not be performed. Thus, the emission layer 220 may not be damaged in the process of forming the pixel-defining layer 119.

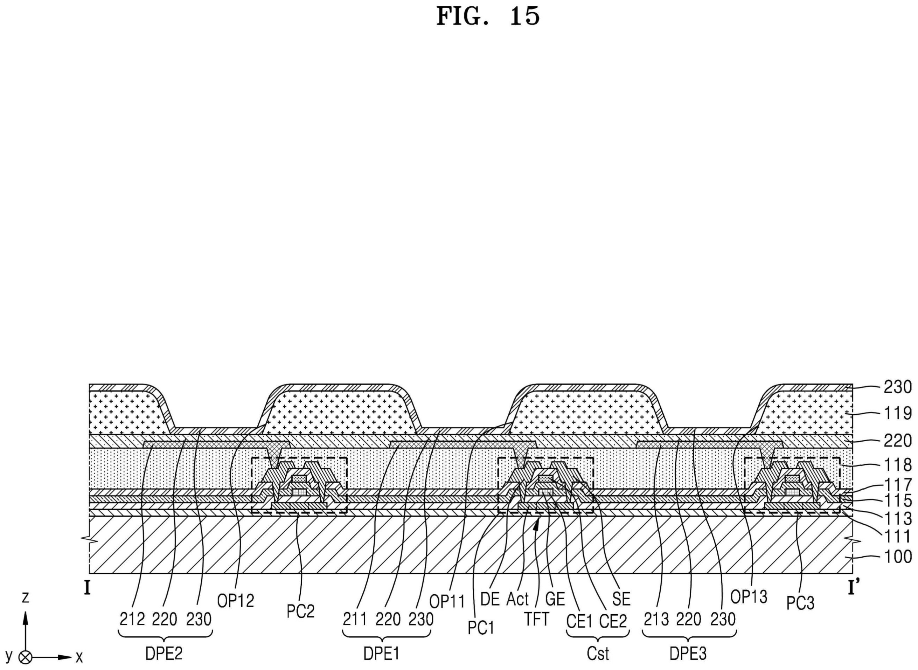

Next, as shown in FIG. 15, the opposite electrode 230 may be formed on the pixel-defining layer 119. The pixel-defining layer 119 may be formed on the emission layer 220, and the emission layer 220 may be formed on the first pixel electrode 211, the second pixel electrode 212, and the third pixel electrode 213. In other words, the opposite electrode 230 may be formed on the first pixel electrode 211, the second pixel electrode 212, and the third pixel electrode 213.

For example, the opposite electrode 230 may be integrally formed as one body to correspond to the first pixel electrode 211, the second pixel electrode 212, and the third pixel electrode 213. Thus, the opposite electrode 230 may overlap all of the first pixel electrode 211, the second pixel electrode 212, and the third pixel electrode 213. Because the first pixel opening OP11 overlaps the first pixel electrode 211, a portion of the emission layer 220 may be arranged between a portion of the opposite electrode 230 and a portion of the first pixel electrode 211, the portions overlapping the first pixel opening OP11. Similarly, a portion of the emission layer 220 may be arranged between a portion of the opposite electrode 230 and a portion of the second pixel electrode 212, the portions overlapping the second pixel opening OP12. Also, a portion of the emission layer 220 may be arranged between a portion of the opposite electrode 230 and a portion of the third pixel electrode 213, the portions overlapping the third pixel opening OP13.

Such an opposite electrode 230 may include a light-transmitting conductive layer including ITO, In₂O₃, or IZO, and may include a semi-transmissive film including metal, such as Al or Ag. For example, the opposite electrode 230 may be a semi-transmissive film including Mg or Ag.

In general, an emission layer is formed by applying an emission layer forming material into a pixel opening defined in a pixel-defining layer and drying the same. The emission layer forming material is a solution prepared by mixing an organic material forming an emission layer with a solvent. In this case, during a process of drying the emission layer forming material, solid content (e.g., an organic material included in the emission layer) included in the emission layer forming material moves toward an edge of the pixel opening. Thus, a thickness of a portion of the emission layer adjacent to the pixel opening may be greater than a thickness of a portion of the emission layer spaced apart from the pixel opening. In other words, a portion of the emission layer formed on the pixel electrode may not have a substantially uniform thickness. In other words, when the emission layer is formed by applying the emission layer forming material into the pixel opening defined in the pixel-defining layer and drying the same, a coffee ring effect may occur in the drying process for the emission layer forming material.

However, in the method of manufacturing a display apparatus, the emission layer 220 may be formed integrally across the first pixel electrode 211, the second pixel electrode 212, and the third pixel electrode 213 before the pixel-defining layer 119 is formed. Thus, a portion of the emission layer formed on the pixel electrode has a substantially uniform thickness. For example, a portion of the emission layer 220 formed on the first pixel electrode 211 may have a substantially uniform thickness. In addition, a portion of the emission layer 220 formed on the second pixel electrode 212 and a portion of the emission layer 220 formed on the third pixel electrode 213 may also have a substantially uniform thickness. Therefore, the emission efficiency of the display apparatus 1 may be improved.

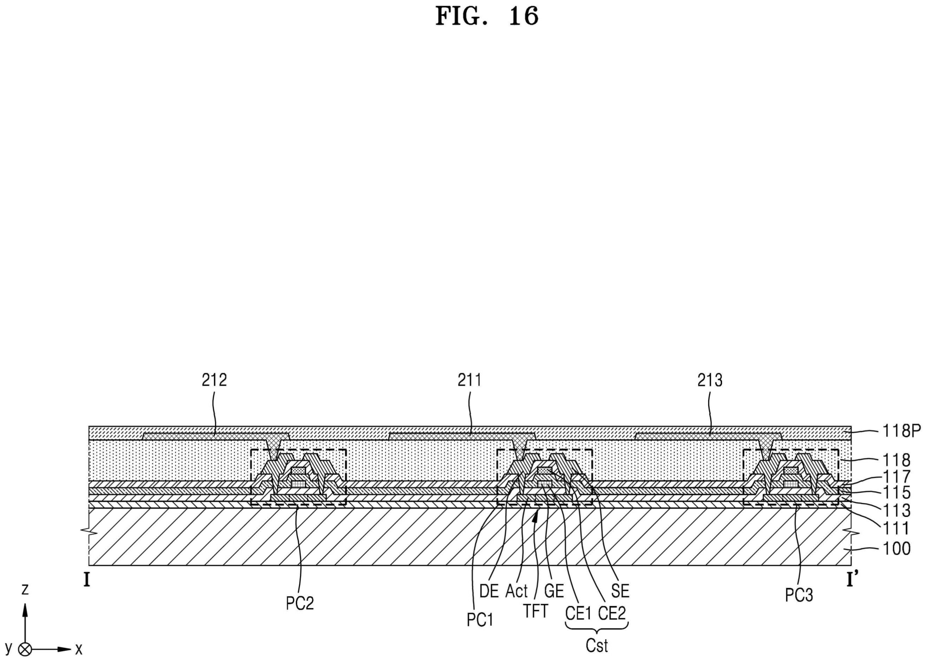

FIGS. 16 to 18 are schematic cross-sectional views for describing a method of manufacturing a display apparatus 1, according to one or more embodiments. For example, FIGS. 16 to 18 are cross-sectional views schematically illustrating a process of forming the emission layer 220 of the display apparatus 1 of FIG. 8. The method of manufacturing a display apparatus corresponds to a modification of the method of manufacturing a display apparatus, described with reference to FIGS. 11 to 15, and thus descriptions below are focused on differences from the method of manufacturing a display apparatus, described with reference to FIGS. 11 to 15. In FIGS. 16 to 18, same reference characters as those of FIGS. 11 to 15 denote a same member, and redundant descriptions thereof are omitted.

In the method of manufacturing a display apparatus, the first pixel electrode 211 may be formed on the planarization layer 118, the pixel-defining layer 119 may be formed on the emission layer 220, and the opposite electrode 230 may be formed on the pixel-defining layer 119. This process may be identical to that of the method of manufacturing a display apparatus, described with reference to FIGS. 11 and 13 to 15, and thus redundant descriptions related thereto are omitted. However, in the method of manufacturing a display apparatus, as shown in FIGS. 16 to 18, the emission layer 220 is formed after the planarization auxiliary layer 118A is formed on the planarization layer 118 between the first pixel electrode 211 and the second pixel electrode 212 and between the first pixel electrode 211 and the third pixel electrode 213.

First, as shown in FIG. 16, a preliminary planarization auxiliary layer 118P may cover the first pixel electrode 211, the second pixel electrode 212, and the third pixel electrode 213. In other words, the preliminary planarization auxiliary layer 118P may be integrally provided as one body over the first pixel electrode 211, the second pixel electrode 212, and the third pixel electrode 213.

Accordingly, a portion of the preliminary planarization auxiliary layer 118P may be arranged on the first pixel electrode 211, the second pixel electrode 212, and the third pixel electrode 213. A portion of the preliminary planarization auxiliary layer 118P may be arranged between the first pixel electrode 211 and the second pixel electrode 212 and between the first pixel electrode 211 and the third pixel electrode 213. For example, a portion of the preliminary planarization auxiliary layer 118P may be arranged on the planarization layer 118 between the first pixel electrode 211 and the second pixel electrode 212 and between the first pixel electrode 211 and the third pixel electrode 213. In addition, a portion of the preliminary planarization auxiliary layer 118P may be arranged between the second pixel electrode 212 and the third pixel electrode 213. In other words, the preliminary planarization auxiliary layer 118P may cover the first pixel electrode 211, the second pixel electrode 212, and the third pixel electrode 213.

Meanwhile, the preliminary planarization auxiliary layer 118P may include a same material as the planarization layer 118. For example, the preliminary planarization auxiliary layer 118P may include an organic insulating material. For example, the preliminary planarization auxiliary layer 118P may include a photoresist, BCB, polyimide, HMDSO, PMMA, polystyrene, a polymer derivative having a phenol-based group, an acryl-based polymer, an imide-based polymer, aryl ether-based polymer, an amide-based polymer, a fluorine-based polymer, a p-xylene-based polymer, a vinyl alcohol-based polymer, or a combination thereof.

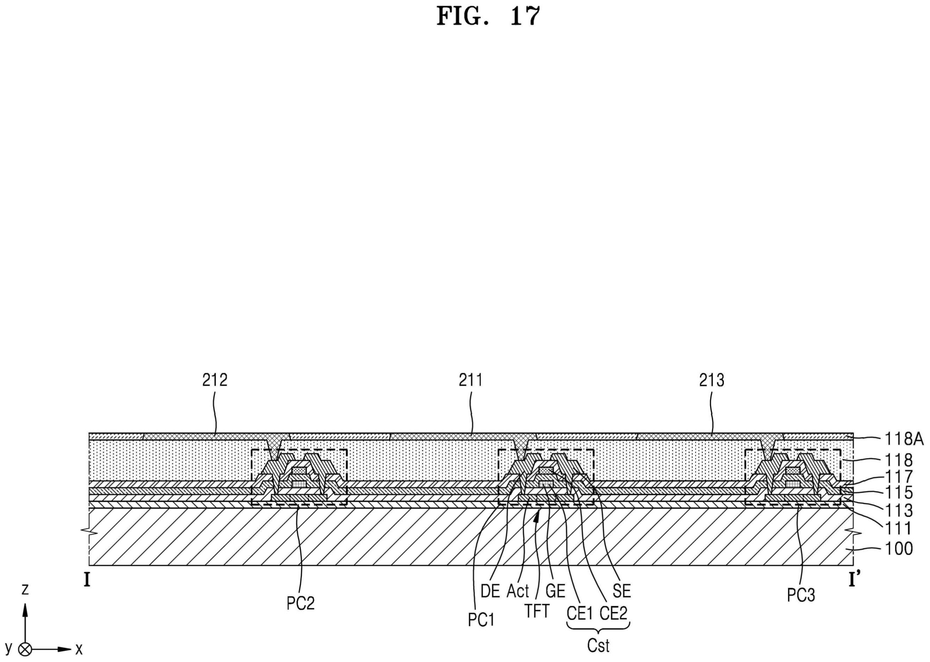

Next, as shown in FIG. 17, the planarization auxiliary layer 118A may be formed by removing a portion of the preliminary planarization auxiliary layer 118P. In other words, when it is referred that a direction perpendicular to the substrate 100 is a third direction (e.g., a z-axis direction), a portion of the preliminary planarization auxiliary layer 118P where a length from the preliminary planarization auxiliary layer 118P to the substrate 100 in the third direction (e.g., the z-axis direction) is greater than a length from the first pixel electrode 211 to the substrate 100 in the third direction (e.g., the z-axis direction) may be removed. Thus, the upper surface of the first pixel electrode 211 may be exposed, and the upper surface of the planarization auxiliary layer 118A may form a flat surface with the upper surface of the first pixel electrode 211. In addition, the upper surface of the second pixel electrode 212 and the upper surface of the third pixel electrode 213 may also be exposed, and the upper surface of the planarization auxiliary layer 118A may form a flat surface with the upper surface of the first pixel electrode 211, the upper surface of the second pixel electrode 212, and the upper surface of the third pixel electrode 213.

In one or more embodiments, a portion of the preliminary planarization auxiliary layer 118P may be removed through a polishing process (e.g., a chemical mechanical polishing (CMP) process). Thus, the upper surface of the planarization auxiliary layer 118A may form a flat (e.g., substantially flat) surface with (e.g., may be substantially coplanar with) the upper surface of the first pixel electrode 211, the upper surface of the second pixel electrode 212, and the upper surface of the third pixel electrode 213. In other words, the upper surface of the planarization auxiliary layer 118A may form a flat surface with the upper surface of the first pixel electrode 211, the upper surface of the second pixel electrode 212, and the upper surface of the third pixel electrode 213 without forming a step.

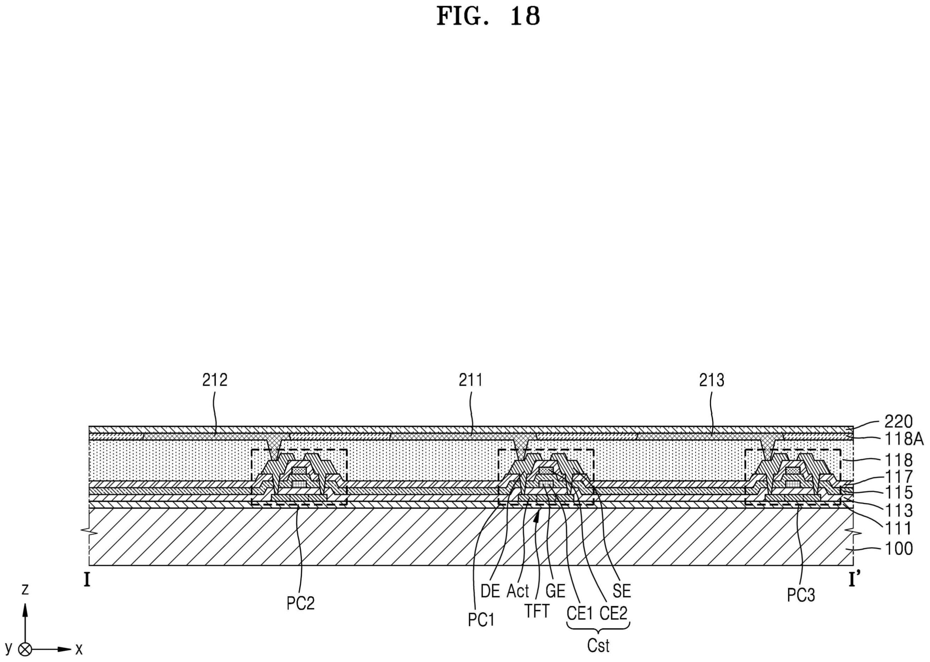

Next, as shown in FIG. 18, the emission layer 220 may be formed on the first pixel electrode 211. Because the upper surface of the planarization auxiliary layer 118A forms a flat surface with the upper surface of the first pixel electrode 211, the upper surface of the second pixel electrode 212, and the upper surface of the third pixel electrode 213, the emission layer 220 formed on such a flat surface may have a more uniform thickness.

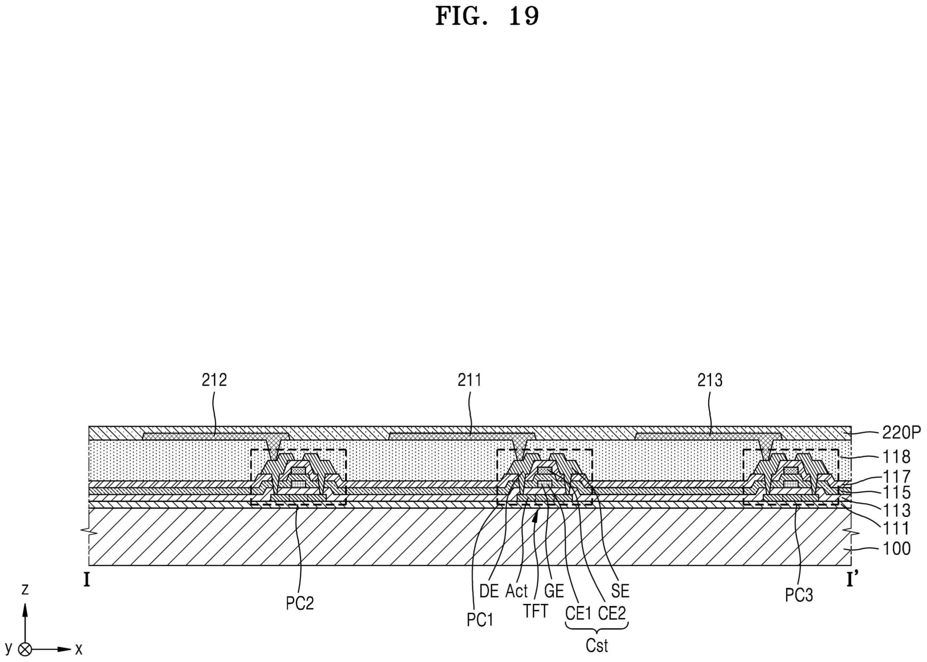

FIGS. 19 to 21 are schematic cross-sectional views for describing a method of manufacturing the display apparatus 1, according to one or more embodiments. For example, FIGS. 19 to 21 are cross-sectional views schematically illustrating a process of forming the emission layer 220 of the display apparatus 1 of FIG. 9. The method of manufacturing a display apparatus corresponds to a modification of the method of manufacturing a display apparatus, described with reference to FIGS. 11 to 15, and thus descriptions below are focused on differences from the method of manufacturing a display apparatus, described with reference to FIGS. 11 to 15. In FIGS. 19 to 21, same reference characters as those of FIGS. 11 to 15 denote a same member, and redundant descriptions thereof are omitted.

In the method of manufacturing a display apparatus, the first pixel electrode 211 may be formed on the planarization layer 118, the pixel-defining layer 119 may be formed on the emission layer 220, and the opposite electrode 230 may be formed on the pixel-defining layer 119. This process is substantially identical to that of the method of manufacturing a display apparatus, described with reference to FIGS. 11 and 13 to 15, and thus redundant descriptions related thereto are omitted. However, in the method of manufacturing a display apparatus, as shown in FIGS. 19 to 21, the emission layer 220 may be formed such that a portion of the emission layer 220 arranged on the first pixel electrode 211, a portion of the emission layer 220 arranged on the second pixel electrode 212, and a portion of the emission layer 220 arranged on the third pixel electrode 213 are disconnected from each other.

First, as shown in FIG. 19, a preliminary emission layer 220P may be formed on the first pixel electrode 211. For example, the preliminary emission layer 220P may be integrally formed as one body across the first pixel electrode 211, the second pixel electrode 212, and the third pixel electrode 213. For example, the preliminary emission layer 220P may be formed on the entire surface of the substrate 100. Accordingly, a portion of the preliminary emission layer 220P may be formed on the first pixel electrode 211, the second pixel electrode 212, and the third pixel electrode 213, and a portion of the preliminary emission layer 220P may be formed on the planarization layer 118 between the first pixel electrode 211 and the second pixel electrode 212 and between the first pixel electrode 211 and the third pixel electrode 213. In addition, a portion of the preliminary emission layer 220P may be formed on the planarization layer 118 between the second pixel electrode 212 and the third pixel electrode 213.

Such a preliminary emission layer 220P may include a polymer material based on PPV or polyfluorene.

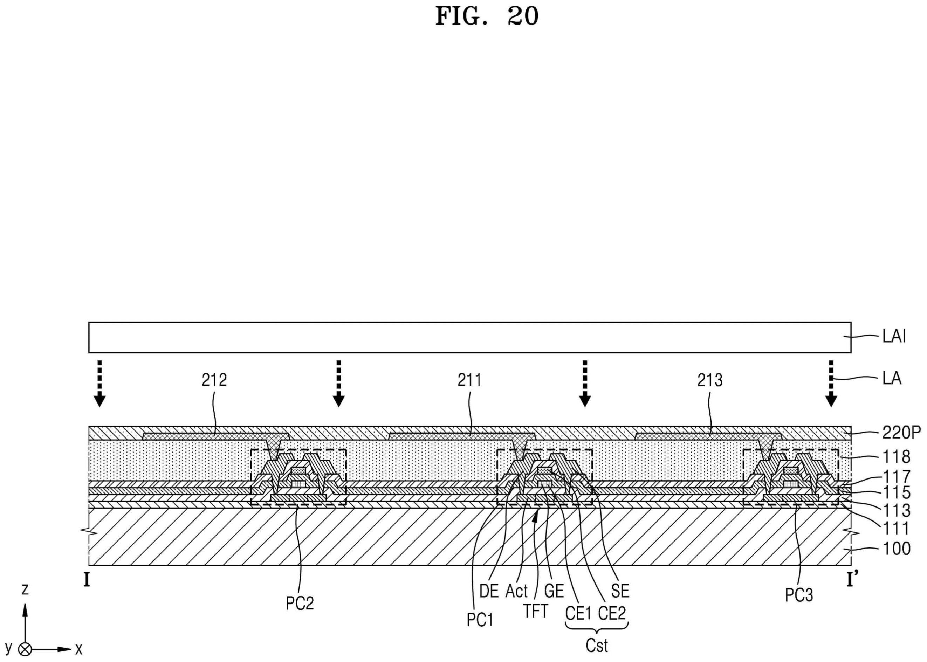

Next, as shown in FIG. 20, a portion of the preliminary emission layer 220P may be removed. For example, a laser irradiation portion LAI may be used to remove a portion of the preliminary emission layer 220P. In other words, the laser irradiation portion LAI may radiate laser LA to a portion of the preliminary emission layer 220P formed on the planarization layer 118 between the first pixel electrode 211 and the second pixel electrode 212 and between the first pixel electrode 211 and the third pixel electrode 213. In addition, the laser irradiation portion LAI may radiate the laser LA to a portion of the preliminary emission layer 220P formed on the planarization layer 118 between the second pixel electrode 212 and the third pixel electrode 213. However, types of a laser that may be used as the laser LA are not necessarily limited thereto. Any laser that ensures removal of an organic material may be used as the laser LA for removing a portion of the preliminary emission layer 220P.

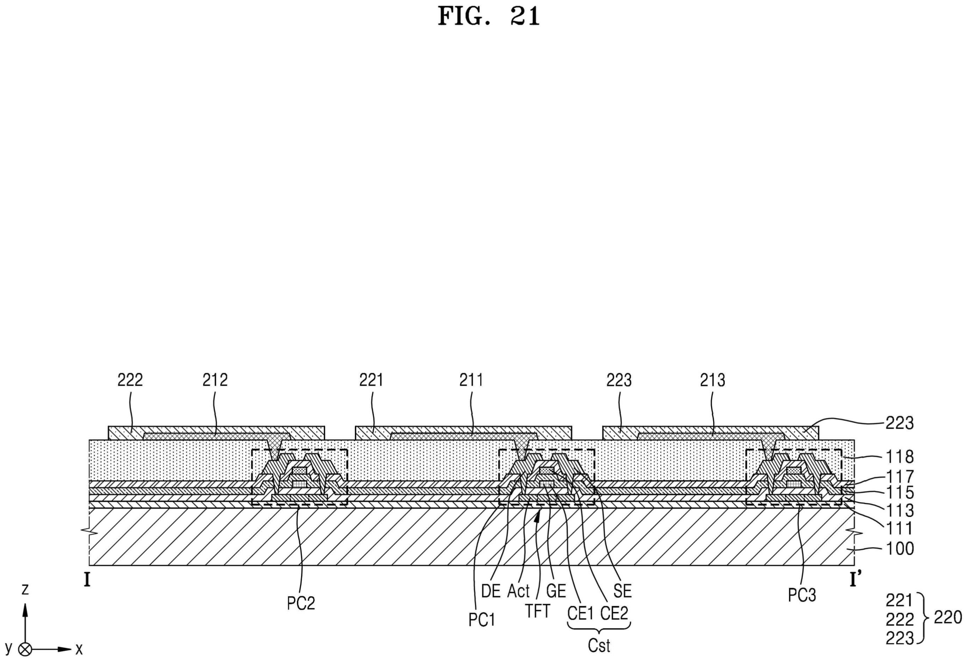

Thus, the emission layer 220 as shown in FIG. 21 may be formed. In other words, a portion of the preliminary emission layer 220P formed on the planarization layer 118 between the first pixel electrode 211 and the second pixel electrode 212 and between the first pixel electrode 211 and the third pixel electrode 213 may be removed. In addition, a portion of the preliminary emission layer 220P formed on the planarization layer 118 between the second pixel electrode 212 and the third pixel electrode 213 may be removed. Thus, the portion of the preliminary emission layer 220P arranged on the first pixel electrode 211, the portion of the preliminary emission layer 220P arranged on the second pixel electrode 212, and the portion of the preliminary emission layer 220P arranged on the third pixel electrode 213 may be disconnected from each other.

In other words, at least a portion of the first emission layer 221 of FIG. 21 may be the portion of the preliminary emission layer 220P formed on the first pixel electrode 211, at least a portion of the second emission layer 222 of FIG. 21 may be the portion of the preliminary emission layer 220P formed on the second pixel electrode 212, and at least a portion of the third emission layer 223 of FIG. 21 may be the portion of the preliminary emission layer 220P formed on the third pixel electrode 213. In other words, the emission layer 220 may include the first emission layer 221, the second emission layer 222, and the third emission layer 223, and the first emission layer 221, the second emission layer 222, and the third emission layer 223 may be arranged on the planarization layer 118 and spaced apart from each other.

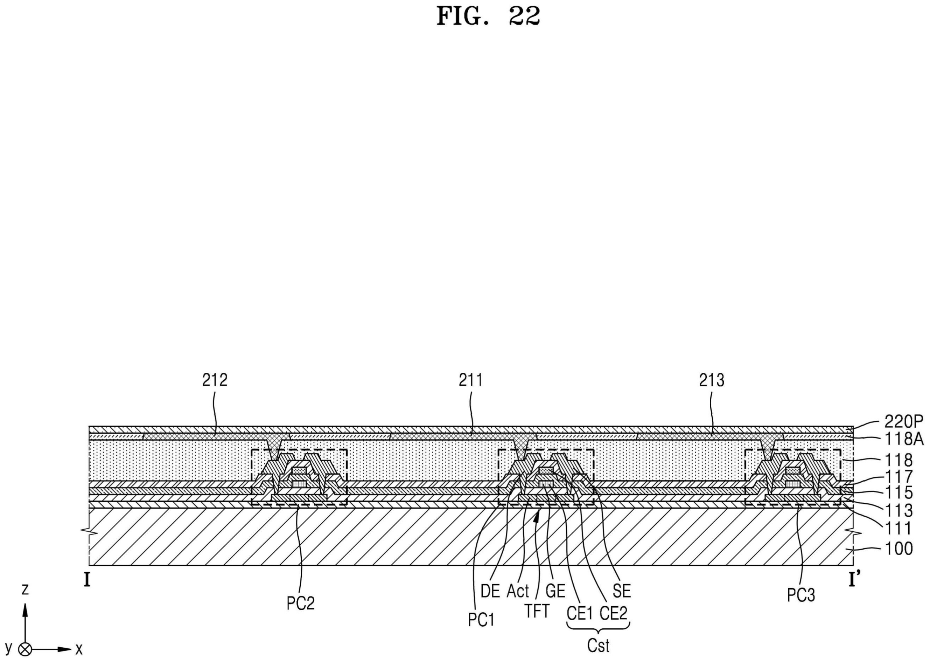

FIGS. 22 to 24 are schematic cross-sectional views for describing a method of manufacturing the display apparatus 1, according to one or more embodiments. For example, FIGS. 22 to 24 are cross-sectional views schematically illustrating a process of forming the emission layer 220 of the display apparatus 1 of FIG. 10. The method of manufacturing a display apparatus corresponds to a modification of the method described with reference to FIGS. 16 to 18, and thus descriptions below are focused on differences from the method of manufacturing a display apparatus, described with reference to FIGS. 16 to 18. In FIGS. 22 to 24, same reference characters as those of FIGS. 16to 18 denote a same member, and redundant descriptions thereof are omitted.

In the method of manufacturing a display apparatus, the first pixel electrode 211 may be formed on the planarization layer 118, the pixel-defining layer 119 may be formed on the emission layer 220, and the opposite electrode 230 may be formed on the pixel-defining layer 119. This process is substantially identical to that of the method of manufacturing a display apparatus, described with reference to FIGS. 11 and 13 to 15, and thus redundant descriptions related thereto are omitted. However, in the method of manufacturing a display apparatus, as shown in FIGS. 22 to 24, the emission layer 220 may be formed such that a portion of the emission layer 220 arranged on the first pixel electrode 211, a portion of the emission layer 220 arranged on the second pixel electrode 212, and a portion of the emission layer 220 arranged on the third pixel electrode 213 are disconnected from each other.

First, as shown in FIG. 22, the preliminary emission layer 220P may be formed on the first pixel electrode 211. For example, the preliminary emission layer 220P may be integrally formed as one body across the first pixel electrode 211, the second pixel electrode 212, and the third pixel electrode 213. For example, the preliminary emission layer 220P may be formed on the entire surface of the substrate 100. Accordingly, a portion of the preliminary emission layer 220P may be formed on the first pixel electrode 211, the second pixel electrode 212, and the third pixel electrode 213, and a portion of the preliminary emission layer 220P may be formed on the planarization auxiliary layer 118A between the first pixel electrode 211 and the second pixel electrode 212 and between the first pixel electrode 211 and the third pixel electrode 213. In addition, a portion of the preliminary emission layer 220P may be formed on the planarization auxiliary layer 118A between the second pixel electrode 212 and the third pixel electrode 213.

Such a preliminary emission layer 220P may include a polymer material based on PPV or polyfluorene.

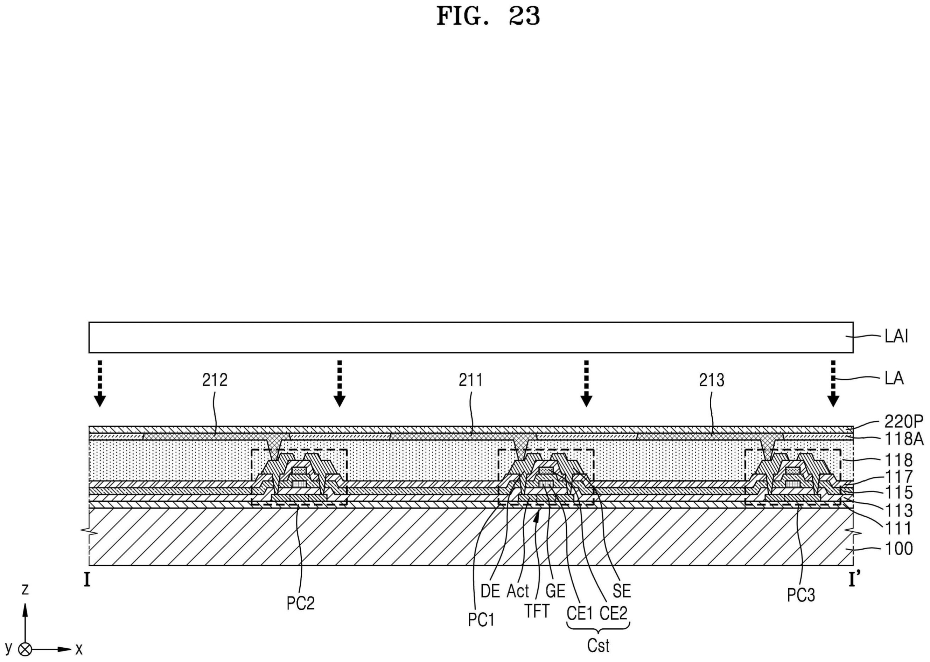

Next, as shown in FIG. 23, a portion of the preliminary emission layer 220P may be removed. For example, the laser irradiation portion LAI may be used to remove a portion of the preliminary emission layer 220P. In other words, the laser irradiation portion LAI may radiate laser LA to a portion of the preliminary emission layer 220P formed on the planarization auxiliary layer 118A between the first pixel electrode 211 and the second pixel electrode 212 and between the first pixel electrode 211 and the third pixel electrode 213. In addition, the laser irradiation portion LAI may radiate the laser LA to a portion of the preliminary emission layer 220P formed on the planarization auxiliary layer 118A between the second pixel electrode 212 and the third pixel electrode 213. However, types of a laser that may be used as the laser LA are not necessarily limited thereto. Any laser that ensures removal of an organic material may be used as the laser LA for removing a portion of the preliminary emission layer 220P.

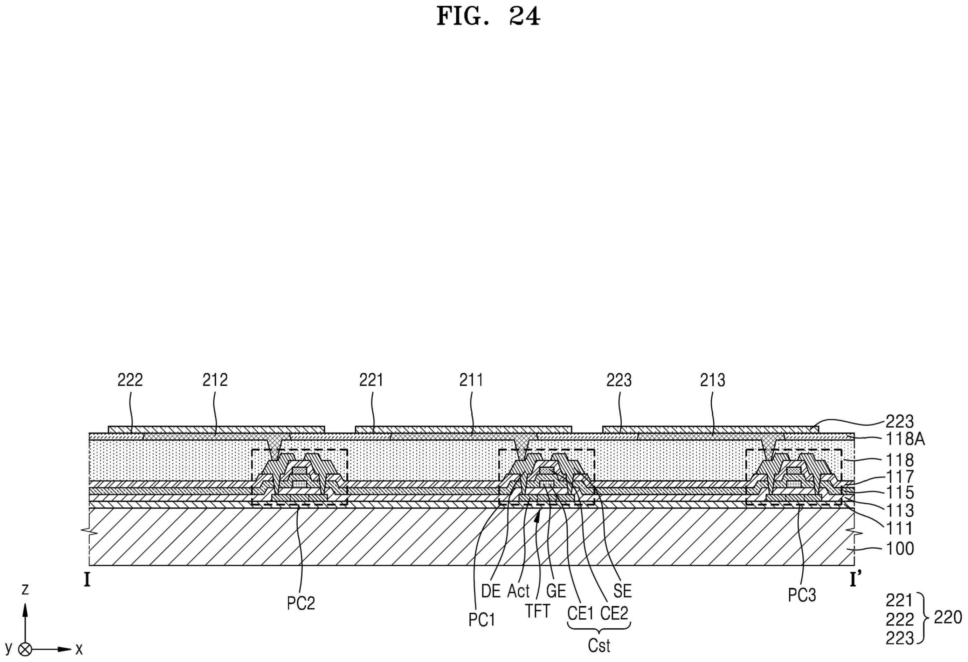

Thus, the emission layer 220 as shown in FIG. 24 may be formed. In other words, a portion of the preliminary emission layer 220P formed on the planarization auxiliary layer 118A between the first pixel electrode 211 and the second pixel electrode 212 and between the first pixel electrode 211 and the third pixel electrode 213 may be removed. In addition, a portion of the preliminary emission layer 220P formed on the planarization auxiliary layer 118A between the second pixel electrode 212 and the third pixel electrode 213 may be removed. Thus, the portion of the preliminary emission layer 220P arranged on the first pixel electrode 211, the portion of the preliminary emission layer 220P arranged on the second pixel electrode 212, and the portion of the preliminary emission layer 220P arranged on the third pixel electrode 213 may be disconnected from each other.

In other words, at least a portion of the first emission layer 221 of FIG. 24 may be the portion of the preliminary emission layer 220P formed on the first pixel electrode 211, at least a portion of the second emission layer 222 of FIG. 24 may be the portion of the preliminary emission layer 220P formed on the second pixel electrode 212, and at least a portion of the third emission layer 223 of FIG. 24 may be the portion of the preliminary emission layer 220P formed on the third pixel electrode 213. In other words, the emission layer 220 may include the first emission layer 221, the second emission layer 222, and the third emission layer 223, and the first emission layer 221, the second emission layer 222, and the third emission layer 223 may be arranged on the planarization layer 118 and spaced apart from each other.

In FIG. 5, the first color conversion layer 451, the second color conversion layer 452, and the light-transmissive layer 453 are arranged on the encapsulation layer 300 such that the display apparatus 1 may generate a color image. However, other embodiments are not limited thereto. For example, color filter layers may be arranged on the encapsulation layer 300 so that the display apparatus 1 may generate a color image.

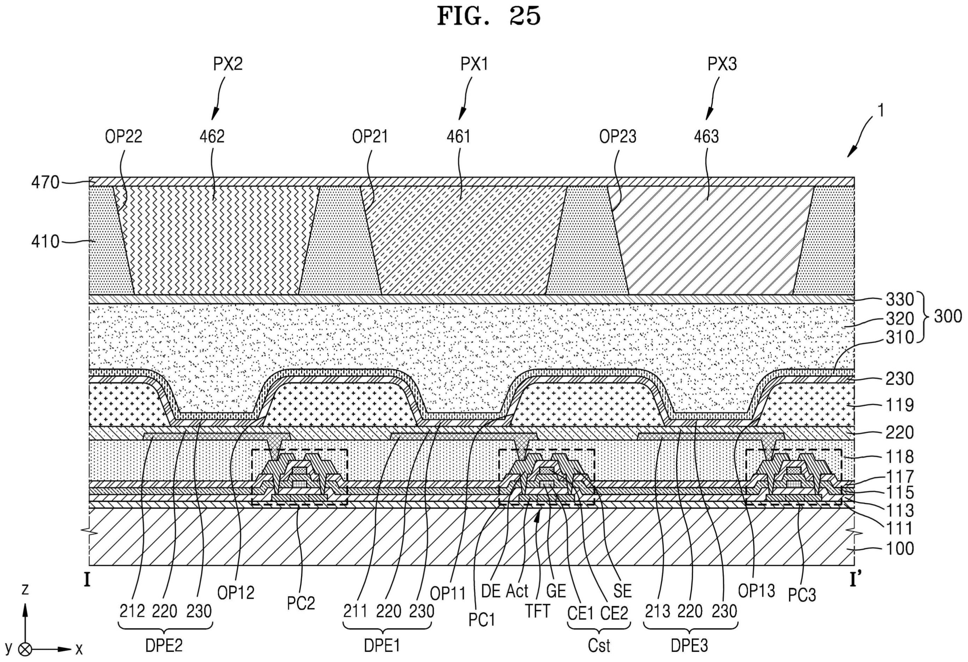

FIG. 25 is a cross-sectional view schematically illustrating the display apparatus 1 according to one or more embodiments. The display apparatus 1 is similar to that described above with reference to FIGS. 1 to 7, and thus, descriptions below are mainly focused on differences from the display apparatus 1 described above with reference to FIGS. 1 to 7. In FIG. 25, same reference characters as those of FIGS. 1 to 7 denote a same member, and redundant descriptions thereof are omitted.

In the display apparatus 1 described above with reference to FIGS. 1 to 7, the light-shielding wall portion 410 may be arranged on the encapsulation layer 300, and the light-shielding wall portion 410 may define the first color conversion opening OP21, the second color conversion opening OP22, and the third color conversion opening OP23. Also in the display apparatus 1, the light-shielding wall portion 410 may be arranged on the encapsulation layer 300, and the light-shielding wall portion 410 may define the first color conversion opening OP21, the second color conversion opening OP22, and the third color conversion opening OP23.

In the display apparatus 1 described above with reference to FIGS. 1 to 7, the first color conversion layer 451 may be arranged in the first color conversion opening OP21, the second color conversion layer 452 may be arranged in the second color conversion opening OP22, and the light-transmissive layer 453 may be arranged in the third color conversion opening OP23 (e.g., the light-transmissive opening).

However, as shown in FIG. 25, in the display apparatus 1, a first color filter layer 461 may be arranged in the first color conversion opening OP21, a second color filter layer 462 may be arranged in the second color conversion opening OP22, and a third color filter layer 463 may be arranged in the third color conversion opening OP23/light-transmissive opening.

The first color filter layer 461, the second color filter layer 462, and the third color filter layer 463 may optionally transmit light of a corresponding color (e.g., predetermined color). For example, the first color filter layer 461 may transmit green light, the second color filter layer 462 may transmit red light, and the third color filter layer 463 may transmit blue light.

For example, the first color filter layer 461 may be a green color filter. The first color filter layer 461 may transmit only light which belongs in a wavelength band of about 495 nm to about 580 nm. To this end, the first color filter layer 461 may include a green pigment or dye. The second color filter layer 462 may be a red color filter. The second color filter layer 462 may transmit only light which belongs in a wavelength band of about 580 nm to about 780 nm. To this end, the second color filter layer 462 may include a red pigment or dye. The third color filter layer 463 may be a blue color filter. The third color filter layer 463 may transmit only light of a wavelength belonging to about 450 nm to about 495 nm. To this end, the third color filter layer 463 may include a blue pigment or dye.

In this case, light emitted by the first display element DPE1, the second display element DPE2, and the third display element DPE3 may be white light. In general, a wavelength band of white light is evenly distributed across a wavelength band of visible light, which is about 450 nm to about 780 nm. In other words, only a portion of light emitted by the first display element DPE1 belonging to the wavelength band of about 495 nm to about 580 nm may pass through the first color filter layer 461. Similarly, only a portion of light emitted by the second display element DPE2 belonging to the wavelength band of about 580 nm to about 780 nm may pass through the second color filter layer 462, and only a portion of light emitted by the third display element DPE3 belonging to the wavelength band of about 450 nm to about 495 nm may pass through the third color filter layer 463. Thus, the display apparatus 1 may generate a color image by using the first color filter layer 461, the second color filter layer 462, and the third color filter layer 463.

According to the one or more embodiments configured as described above, a display apparatus including an emission layer with substantially uniform thickness so that the emission efficiency is improved, a method of manufacturing the display apparatus, and an electronic apparatus may be implemented. However, the scope of the disclosure is not limited by this aspect.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (1) comprising:
a substrate (100);
a planarization layer (118) above the substrate (100);
a first pixel electrode (211) above the planarization layer (118);
an emission layer (220) above the first pixel electrode (211);
an opposite electrode (230) above the emission layer (220); and
a pixel-defining layer (119) between the emission layer (220) and the opposite electrode (230), and defining a first pixel opening (OP11) overlapping the first pixel electrode (211).

2. The display apparatus (1) of claim 1, wherein a portion of the emission layer (220) is between a portion of the pixel-defining layer (119) defining the first pixel opening (OP11) and a portion of the first pixel electrode (211), and
wherein another portion of the emission layer (220) is between a portion of the opposite electrode (230) overlapping the first pixel opening (OP11) and another portion of the first pixel electrode (211).

3. The display apparatus (1) of claim 1 or 2, further comprising:
a second pixel electrode (212) above the planarization layer (118), and spaced apart from the first pixel electrode (211); and
a third pixel electrode (213) above the planarization layer (118) opposite the second pixel electrode (212) with the first pixel electrode (211) therebetween,
wherein the emission layer (220) overlaps the first pixel electrode (211), the second pixel electrode (212), and the third pixel electrode (213), and
wherein the pixel-defining layer (119) defines a second pixel opening (OP12) overlapping the second pixel electrode (212), and a third pixel opening (OP13) overlapping the third pixel electrode (213).

4. The display apparatus (1) of claim 3, wherein portions of the emission layer (220) are respectively between the first pixel electrode (211) and the second pixel electrode (212) and between the first pixel electrode (211) and the third pixel electrode (213).

5. The display apparatus (1) of claim 3 or 4, further comprising:
an encapsulation layer (300) above the opposite electrode (230), and comprising at least one inorganic layer and at least one organic layer;
a light-shielding wall portion (410) above the encapsulation layer (300), and defining a first color conversion opening (OP21) overlapping the first pixel opening (OP11), a second color conversion opening (OP22) overlapping the second pixel opening (OP12), and a light-transmissive opening (OP23) overlapping the third pixel opening (OP13);
a first color conversion layer (451) in the first color conversion opening (OP21);
a second color conversion layer (452) in the second color conversion opening (OP22); and
a light-transmissive layer (453) in the light-transmissive opening (OP23).

6. The display apparatus (1) of claim 3 or 4, further comprising:
an encapsulation layer (300) above the opposite electrode (230), and comprising at least one inorganic layer and at least one organic layer;
a light-shielding wall portion (410) above the encapsulation layer (300), and defining a first color conversion opening (OP21) overlapping the first pixel opening (OP11), a second color conversion opening (OP22) overlapping the second pixel opening (OP12), and a third color conversion opening (OP23) overlapping the third pixel opening (OP13);
a first color filter layer (461) in the first color conversion opening (OP21);
a second color filter layer (462) in the second color conversion opening (OP22); and
a third color filter layer (463) in the third color conversion opening (OP23).

7. The display apparatus (1) of claim 3 or 4, further comprising a planarization auxiliary layer (118A) above the planarization layer (118) between the first pixel electrode (211) and the second pixel electrode (212) and between the first pixel electrode (211) and the third pixel electrode (213), directly contacting the planarization layer (118), and directly contacting portions of the emission layer (220) respectively between the first pixel electrode (211) and the second pixel electrode (212) and between the first pixel electrode (211) and the third pixel electrode (213).

8. The display apparatus (1) of claim 7, wherein an upper surface of the planarization auxiliary layer (118A), an upper surface of the first pixel electrode (211), an upper surface of the second pixel electrode (212), and an upper surface of the third pixel electrode (213) are substantially coplanar.

9. The display apparatus (1) of claim 7 or 8, wherein the planarization auxiliary layer (118A) comprises a same material as the planarization layer (118).

10. The display apparatus (1) of claim 1, further comprising:
a second pixel electrode (212) above the planarization layer (118), and spaced apart from the first pixel electrode (211); and
a third pixel electrode (213) above the planarization layer (118), and opposite to the second pixel electrode (212) with the first pixel electrode (211) therebetween,
wherein the emission layer (220) comprises a first emission layer (221) between the first pixel electrode (211) and the opposite electrode (230), a second emission layer (222) between the second pixel electrode (212) and the opposite electrode (230), and a third emission layer (223) between the third pixel electrode (213) and the opposite electrode (230), the first, second, and third emission layers (223) being spaced apart from each other, and
wherein the pixel-defining layer (119) defines a second pixel opening (OP12) overlapping the second pixel electrode (212), and a third pixel opening (OP13) overlapping the third pixel electrode (213).

11. The display apparatus (1) of claim 10, wherein portions of the pixel-defining layer (119) respectively between the first emission layer (221) and the second emission layer (222) and between the first emission layer (221) and the third emission layer (223) directly contact the planarization layer (118).

12. The display apparatus (1) of claim 10 or 11, further comprising a planarization auxiliary layer (118A) above the planarization layer (118) between the first pixel electrode (211) and the second pixel electrode (212) and between the first pixel electrode (211) and the third pixel electrode (213), directly contacting the planarization layer (118), and directly contacting portions of the pixel-defining layer (119) respectively between the first pixel electrode (211) and the second pixel electrode (212) and between the first pixel electrode (211) and the third pixel electrode (213).

13. A method of manufacturing a display apparatus (1), the method comprising:
placing a first pixel electrode (211) above a planarization layer (118) that is above a substrate (100);
placing an emission layer (220) above the first pixel electrode (211);
placing a pixel-defining layer (119) above the emission layer (220) and defining a first pixel opening (OP11) overlapping the first pixel electrode (211); and
placing an opposite electrode (230) above the pixel-defining layer (119).

14. The method of claim 13, wherein a portion of the emission layer (220) is between a portion of the pixel-defining layer (119) defining the first pixel opening (OP11) and a portion of the first pixel electrode (211), and
wherein another portion of the emission layer (220) is between a portion of the opposite electrode (230) overlapping the first pixel opening (OP11) and another portion of the first pixel electrode (211).

15. An electronic apparatus (2) comprising:
a display apparatus (1); and
a housing (3) accommodating the display apparatus (1) and forming an exterior of the electronic apparatus (2),
wherein the display apparatus (1) comprises:
a substrate (100);
a planarization layer (118) above the substrate (100);
a first pixel electrode (211) above the planarization layer (118);
an emission layer (220) above the first pixel electrode (211);
an opposite electrode (230) above the emission layer (220); and
a pixel-defining layer (119) between the emission layer (220) and the opposite electrode (230) and defining a first pixel opening (OP11) overlapping the first pixel electrode (211).
